(19) Europäisches Patentamt / European Patent Office / Office européen des brevets

(11) **EP 4 113 133 B1**

(12) **EUROPEAN PATENT SPECIFICATION**

(45) Date of publication and mention
of the grant of the patent:
**24.09.2025 Bulletin 2025/39**

(21) Application number: **21813357.7**

(22) Date of filing: **06.05.2021**

(51) International Patent Classification (IPC):
*G01R 27/26* (2006.01)   *H02J 50/60* (2016.01)
*H02J 50/12* (2016.01)   *H02J 50/80* (2016.01)

(52) Cooperative Patent Classification (CPC):
**H02J 50/12; G01R 27/2694; H02J 50/60;
H02J 50/80;** Y02B 70/10

(86) International application number:
**PCT/CN2021/091953**

(87) International publication number:
**WO 2021/238598 (02.12.2021 Gazette 2021/48)**

(54) **QUALITY FACTOR DETECTION CIRCUIT AND DETECTION METHOD BASED ON OSCILLATING CIRCUIT, AND ELECTRONIC DEVICE**

QUALITÄTSFAKTORDETEKTIONSSCHALTUNG UND DETEKTIONSVERFAHREN AUF BASIS EINER OSZILLATIONSSCHALTUNG UND ELEKTRONISCHE VORRICHTUNG

CIRCUIT DE DÉTECTION ET PROCÉDÉ DE DÉTECTION DE FACTEUR DE QUALITÉ FONDÉS SUR UN CIRCUIT OSCILLANT, ET DISPOSITIF ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.05.2020 CN 202010463813**

(43) Date of publication of application:
**04.01.2023 Bulletin 2023/01**

(73) Proprietor: **Huawei Digital Power Technologies
Co., Ltd.
Shenzhen, Guangdong 518043 (CN)**

(72) Inventors:
• **LI, Yuechao
Shenzhen, Guangdong 518129 (CN)**

• **ZHOU, Di
Shenzhen, Guangdong 518129 (CN)**
• **WANG, Yong
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(56) References cited:
CN-A- 106 953 427      CN-A- 108 336 834
CN-A- 109 004 771      CN-A- 111 201 443
CN-A- 111 812 408      US-A- 5 278 512
US-A1- 2013 176 023

## Description

### TECHNICAL FIELD

This application relates to the field of electronic technologies, and in particular, to a quality factor measurement circuit and measurement method based on an oscillating circuit, and an electronic device.

### BACKGROUND

As wireless charging technology becomes popular, many wireless charging products have emerged in the market, among which mobile phone transmitters based on a wireless power consortium (wireless power consortium, WPC) Qi standard have gained the largest share.

A wireless charging product, during application, is usually in an open scenario. For example, a mobile phone having a wireless charging function is charged with a charger as an accessory, and the mobile phone and the charger are independent and separable product forms. A transmit (transmit, TX) apparatus in the accessory needs to perform real-time detection and identification of a receive (receive, RX) apparatus (usually installed inside an electronic device, such as a mobile phone, having a wireless charging function) placed in the accessory, and upon identifying the receive apparatus, starts to control the charging to complete the transfer of electrical energy. In addition, it is also required to determine whether there is a foreign object between the transmit apparatus and the receive apparatus. If the foreign object cannot be accurately detected, the foreign object (such as a bank card or an identity card) may be damaged in the charging process, which seriously restricts the development of the wireless charging industry. As such, foreign object detection has become a primary issue in the safety of wireless charging and also a pain point in the industry.

However, the current wireless charging has a limited foreign object detection capability and a small coverage, and many foreign objects cannot be detected, which seriously threatens the safety of wireless charging and is extremely unfavorable for the further development of the industry. At present, a foreign object detection method used is mainly a quality factor (quality factor, Q) value-based detection method. The principle of the Q value-based detection method is: the presence of a foreign object between the transmit apparatus and the receive apparatus affects a parameter of an inductor coil of the transmit apparatus and then affects a Q value of the inductor coil, and therefore a measurement of the Q value of the inductor coil can reflect whether a foreign object is present. Therefore, the accuracy of foreign object detection can be improved by improving the measurement precision and measurement speed of the Q value, and how to measure the Q value quickly with high precision has become a problem that needs to be resolved currently.

US 2013/176023 A1 discloses a detecting device including a reading coil configured to read a magnetic flux generated by a detecting coil for detecting a magnetic field of an electromagnetic wave output from an exciting coil according to the magnetic field. The detecting device further includes a Q-value measuring section configured to measure a Q-value of the detecting coil on a basis of a temporal transition of oscillation of a voltage obtained in the reading coil according to the magnetic flux generated by the detecting coil.

CN 106 953 427 A discloses an energy receiving device, an energy transmitting device, a detection device, and a detection method. The energy receiving device comprises a power receiving coil for receiving power from the energy transmitting device, an energy storage element for storing the power received from the energy transmitting device after receiving a command about foreign matter detection, a storage for storing a Q-value threshold value which will compare with a calculated Q value, and a control unit for supplying the received power to a load connected with the energy receiving device when receiving a charge command from the energy transmitting device, wherein the charge command is released after a result of the foreign matter detection shows that there is no foreign matter.

### SUMMARY

Embodiments of this application provide a quality factor measurement circuit and measurement method based on an oscillating circuit, and an electronic device, so as to obtain a Q value quickly with high precision.

To achieve the foregoing objective, the invention provides a quality factor measurement circuit of claim 1, a quality factor measurement method of claim 4, a quality factor measurement apparatus of claim 6 and an electronic device of claim 7. Further embodiments are disclosed in the dependent claims.

### BRIEF DESCRIPTION OF DRAWINGS

FIG. 1 is a schematic diagram of a structure of a wireless charging system according to an embodiment of this application;

FIG. 2 is a schematic diagram of a structure of an electronic device according to an embodiment of this application;

FIG. 3 is a schematic diagram of a structure of a wireless charging system according to another embodiment of this application;

FIG. 4 is a schematic diagram of a structure of a wireless charging circuit according to another embodiment of this application;

FIG. 5a is a schematic diagram of a structure of a quality factor measurement circuit based on an oscillating circuit according to an embodiment of this application;

FIG. 5b is a schematic diagram of a structure of a quality factor measurement circuit based on an oscillating circuit according to another embodiment of this application;

FIG. 5c is a schematic diagram of a structure of a quality factor measurement circuit based on an oscillating circuit according to still another embodiment of this application;

FIG. 5d is a schematic diagram of a structure of a quality factor measurement circuit based on an oscillating circuit according to yet another embodiment of this application;

FIG. 6 is a schematic flowchart of a quality factor measurement method based on an oscillating circuit according to an embodiment of this application;

FIG. 7a is a schematic diagram of a structure of a quality factor measurement circuit based on an oscillating circuit according to another embodiment of this application;

FIG. 7b is a schematic diagram of a structure of a quality factor measurement circuit based on an oscillating circuit according to still another embodiment of this application;

FIG. 7c is a schematic diagram of a structure of a quality factor measurement circuit based on an oscillating circuit according to yet another embodiment of this application;

FIG. 7d is a schematic diagram of a structure of a quality factor measurement circuit based on an oscillating circuit according to still yet another embodiment of this application;

FIG. 8a is a schematic diagram of a waveform of a damped oscillation voltage Uc according to an embodiment of this application;

FIG. 8b is a schematic diagram of a waveform of a damped oscillation voltage Uc according to another embodiment of this application;

FIG. 9 is an equivalent circuit diagram of a charging loop formed by connecting an inductor L and a capacitor C to a power supply in series according to an embodiment of this application;

FIG. 10 is an equivalent circuit diagram of an LC oscillating loop formed by connecting an inductor and a capacitor, and connecting a predetermined resistor in series to the LC oscillating loop according to an embodiment of this application;

FIG. 11a is a schematic diagram of a waveform of a damped oscillation voltage Uc according to still another embodiment of this application;

FIG. 11b is a schematic diagram of a waveform of a damped oscillation voltage Uc according to yet another embodiment of this application;

FIG. 12a is a schematic diagram of a structure of a quality factor measurement circuit based on an oscillating circuit according to another embodiment helpful for understanding this application but not covered by the claims;

FIG. 12b is a schematic diagram of a structure of a quality factor measurement circuit based on an oscillating circuit according to yet another embodiment helpful for understanding this application but not covered by the claims;

FIG. 13a is a schematic diagram of a structure of a quality factor measurement circuit based on an oscillating circuit according to another embodiment helpful for understanding this application but not covered by the claims;

FIG. 13b is a schematic diagram of a structure of a quality factor measurement circuit based on an oscillating circuit according to still another embodiment helpful for understanding this application but not covered by the claims;

FIG. 14a is a schematic diagram of a structure of a quality factor measurement circuit based on an oscillating circuit according to yet another embodiment of this application;

FIG. 14b is a schematic diagram of a structure of a quality factor measurement circuit based on an oscillating circuit according to still yet another embodiment of this application;

FIG. 15a is a schematic diagram of a structure of a quality factor measurement circuit based on an oscillating circuit according to still another embodiment of this application;

FIG. 15b is a schematic diagram of a structure of a quality factor measurement circuit based on an oscillating circuit according to yet another embodiment of this application;

FIG. 16 is a schematic diagram of a waveform of a damped oscillation voltage Uc according to still another embodiment of this application;

FIG. 17a is a schematic diagram of a structure of a quality factor measurement circuit based on an oscillating circuit according to another embodiment of this application;

FIG. 17b is a schematic diagram of a structure of a quality factor measurement circuit based on an oscillating circuit according to still another embodiment of this application;

FIG. 18a is a schematic diagram of a structure of a quality factor measurement circuit based on an oscillating circuit according to yet another embodiment of this application;

FIG. 18b is a schematic diagram of a structure of a quality factor measurement circuit based on an oscillating circuit according to still yet another embodiment of this application;

FIG. 19 is a schematic diagram of an attenuation curve of a damped oscillation voltage of a capacitor C according to an embodiment of this application;

FIG. 20 is a schematic diagram of a structure of a quality factor measurement apparatus based on an oscillating circuit according to an embodiment of this application; and

FIG. 21 is a schematic diagram of a structure of a quality factor measurement apparatus based on an oscillating circuit according to another embodiment of this application.

## DESCRIPTION OF EMBODIMENTS

The following describes technical solutions in embodiments of this application with reference to accompanying drawings in embodiments of this application. Apparently, the described embodiments are merely some rather than all of the embodiments of this application.

The terms "first" and "second" hereinafter are merely used for the purpose of description, and shall not be understood as an indication or implication of relative importance or implicit indication of a quantity of indicated technical features. Therefore, a feature defined by "first" or "second" may explicitly or implicitly include one or more features.

In addition, in this application, orientation terms such as "upper" and "lower" define orientations of a component schematically placed in the accompanying drawings. It should be understood that these orientation terms are relative concepts and are used for relative description and clarification, and these orientation terms may change accordingly based on changes of the orientations of the component placed in the accompanying drawings.

In this application, unless otherwise expressly specified and defined, the term "connection" may be a manner of electrical connection for implementing signal transmission, and the "connection" may be a direct electrical connection or an indirect electrical connection through an intermediate medium.

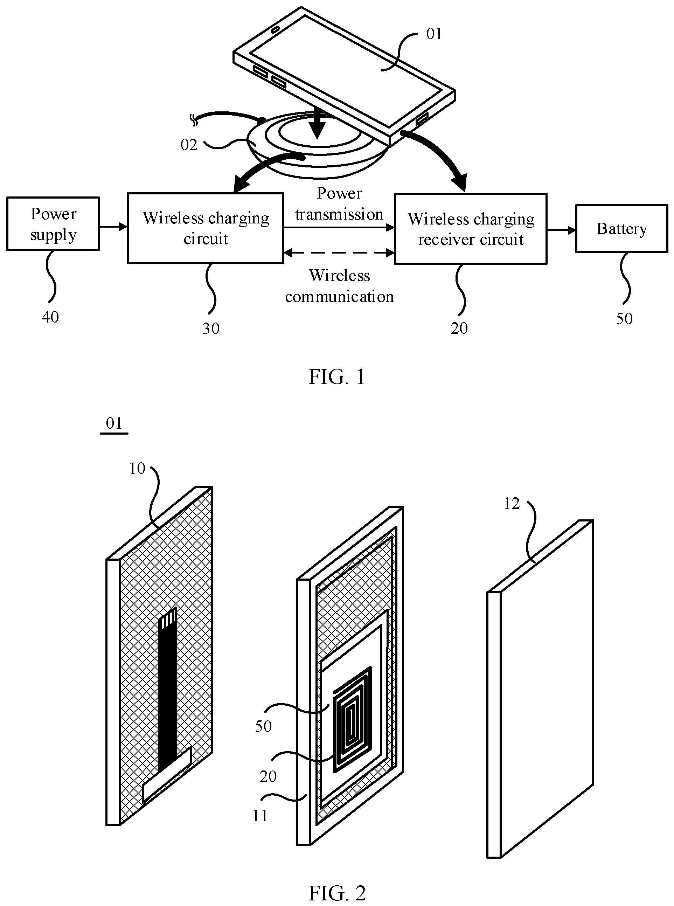

Embodiments of this application are applied to a wireless charging system. The wireless charging system includes an electronic device 01 and a charger 02 shown in FIG. 1. The charger 02 serves as a transmitter device, and the electronic device 01 serves as a receiver device. The electronic device includes a wireless device such as a mobile phone (mobile phone), a tablet computer (pad), a computer having a wireless transceiver function, a smart wearable product (such as a smart watch or a smart band), a virtual reality (virtual reality, VR) terminal device, or an augmented reality (augmented reality, AR) terminal device. The electronic device may also be an electronic product such as an electric vehicle capable of wireless charging, a small household appliance (such as a soy milk maker or a robot vacuum cleaner) capable of wireless charging, or an unmanned aerial vehicle. A specific form of the electronic device is not specially limited in embodiments of this application. For ease of description, an example in which the electronic device 01 is the mobile phone shown in FIG. 1 is used below.

To wirelessly charge the electronic device 01, as shown in FIG. 1, a wireless charging receiver circuit 20 and a battery 50 connected to the wireless charging receiver circuit 20 are provided in the electronic device 01. For example, as shown in FIG. 2, the electronic device 01 mainly includes a display panel (display panel, DP) 10. The display panel 10 may be a liquid crystal display (liquid crystal display, LCD) or an organic light emitting diode (organic light emitting diode, OLED) display. This is not limited in this application. The electronic device 01 further includes a middle frame 11 and a housing 12 shown in FIG. 2. The display panel 10 and the housing 12 are respectively on two sides of the middle frame 11, with the back of the display panel 10 facing the housing 12, and the display panel 10 connected to the housing 12 via the middle frame 11. The wireless charging receiver circuit 20 and the battery 50 may be provided on a side surface of the middle frame 11 facing the housing 12.

The charger 02 includes a wireless charging circuit 30 provided in the charger 02 as shown in FIG. 1, and a power supply 40 connected to the wireless charging circuit 30. The power supply 40 is used to provide electrical energy for charging. In some embodiments of this application, the power supply 40 may be a power adapter. The power supply 40 can convert a 220 V alternating current into a direct current (for example, 5 V or 10 V) based on a requirement for charging power, and transmit the direct current to the wireless charging circuit 30.

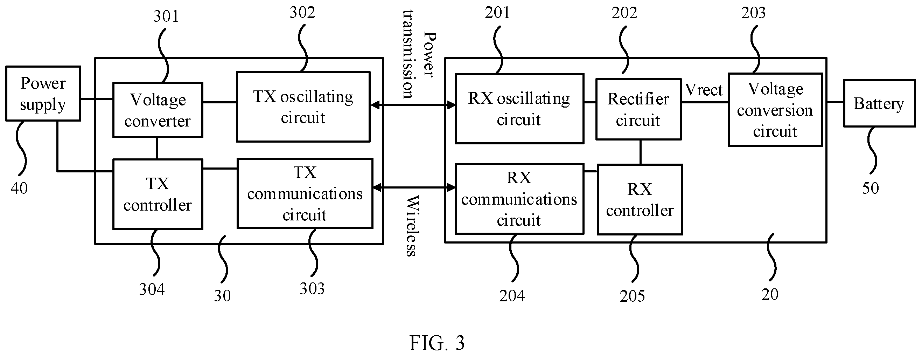

When the electronic device 01 is placed with the side of the housing 12 facing the charger 02, to wirelessly charge the electronic device 01, as shown in FIG. 3, the wireless charging circuit 30 includes a voltage converter 301 and a TX oscillating circuit 302. The voltage converter 301 may be a direct current (direct current, DC) to alternating current (alternating current, AC) converter, that is, DC/AC. The wireless charging receiver circuit 20 further includes an RX oscillating circuit 201 and a rectifier circuit 202.

Based on this, the voltage converter 301 is connected to the power supply 40 and can convert a direct current output by the power supply 40 into an alternating current. In addition, the TX oscillating circuit 302 is connected to the voltage converter 301. After receiving the alternating current output by the voltage converter 301, the TX oscillating circuit 302 may generate an alternating magnetic field. The RX oscillating circuit 201 receives the alternating magnetic field and outputs an alternating current, so that a power from the TX oscillating circuit 301 can be transmitted to the RX oscillating circuit 201.

In addition, the RX oscillating circuit 201 is connected to the rectifier circuit 202, and the rectifier circuit 202 can rectify an alternating current output by the rectifier circuit 202 to generate a rectified voltage Vrect. On this basis, the wireless charging receive circuit 20 further includes at least one stage of voltage conversion circuit 203 connected to the rectifier circuit 202. The voltage conversion circuit 203 may convert the rectified voltage Vrect into a charging voltage (for example, 3.7 V) for the battery 50. After the charging voltage is applied to two terminals of the battery 50, a current output by the voltage conversion circuit 203 may be used to charge the battery 50.

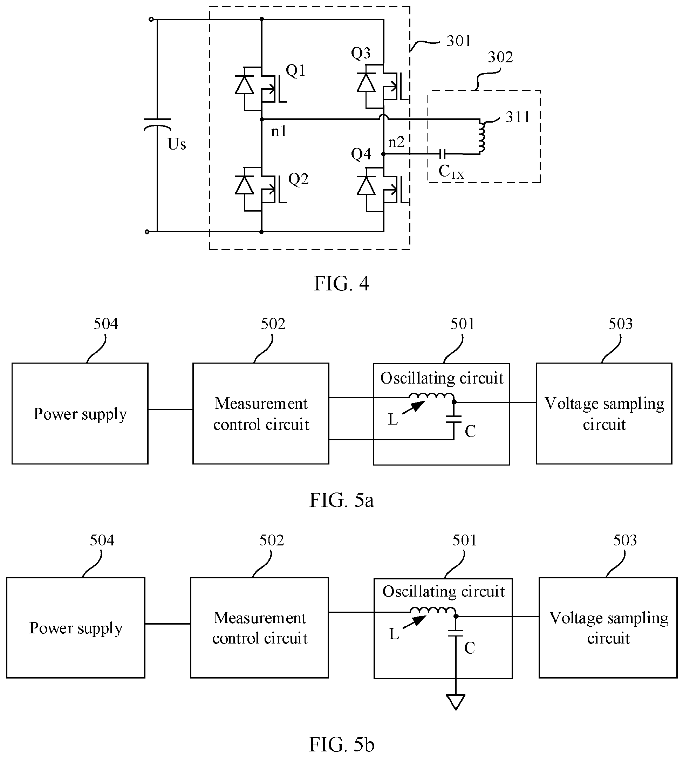

In some embodiments of this application, the voltage conversion circuit 203 includes a DC/DC conversion circuit. The DC/DC conversion circuit may be a buck (Buck) circuit or a switched capacitor (switched capacitor, SC) circuit. An input-output voltage ratio of the buck circuit may be flexibly adjusted. For example, the input-output voltage ratio may be set to a decimal. An input-output voltage ratio of the SC circuit is an integer. However, the SC circuit can withstand a relatively high input-output voltage difference and has a relatively high voltage conversion efficiency. As shown in FIG. 4, a schematic diagram of the wireless charging circuit 30 is provided. The voltage converter 301 includes switching transistors Q1 to Q4, where Q1 and Q2 are connected in series to form a first bridge in parallel with a power supply (the power supply outputs a voltage Us), and Q3 and Q4 are connected in series to form a second bridge in parallel with the power supply. The TX oscillating circuit 302 includes a TX resonant capacitor $C_{TX}$ and an inductor 311 (an inductor coil) that are connected in series as shown in FIG. 4, where the TX resonant capacitor $C_{TX}$ and the inductor 311 are connected in series between a middle node n1 of the first bridge and a middle node n2 of the second bridge. Therefore, after the voltage converter 301 converts the direct current output by the power supply 40 into the alternating current, and transmits the alternating current to the TX oscillating circuit 303, a high-frequency alternating current can be generated on the inductor coil.

In addition, to control the foregoing charging process, wireless communication may be established between the wireless charging circuit 30 and the wireless charging receiver circuit 20. In this case, as shown in FIG. 3, the wireless charging circuit 30 may include a transmitter (transmit, TX) communications circuit 303, and the wireless charging receiver circuit 20 may include a receiver (receive, RX) communications circuit 204. The TX communications circuit 303 and the RX communications circuit 204 may be wirelessly connected by using Bluetooth (bluetooth), wireless fidelity (wireless-fidelity, WiFi), the Zigbee (Zigbee) protocol, a radio frequency identification (radio frequency identification, RFID) technology, a long-range (long range, Lora) wireless technology, and a near-field communications (near field communication, NFC) technology, so that wireless communication can be established between the wireless charging circuit 30 and the wireless charging receiver circuit 20. In this way, a control signal or charging data can be transmitted between the TX communications circuit 303 and the RX communications circuit 204. The charging data may be used to indicate a charging type. For example, the charging data may be a charging protocol, for example, the wireless charging standard Qi developed by the wireless power consortium (wireless power consortium, WPC), such as a BPP (basic power profile) protocol or an EPP (extended power profile) protocol.

In addition, as shown in FIG. 3, the wireless charging circuit 20 further includes an RX controller 205 connected to the RX communications circuit 204. The RX controller 205 can identify a charging protocol sent by a TX controller 304 to the RX communications circuit 204 via the TX communications circuit 303 to determine the charging type of the electronic device 01. For example, the charging type may be a first charging type (such as low-power charging suitable for slow charging), or the charging type may be a second charging type (such as high-power charging suitable for fast charging).

In addition, to implement foreign object detection, an embodiment of this application provides a quality factor measurement circuit based on an oscillating circuit. The oscillating circuit may be the TX oscillating circuit of the wireless charging circuit in the foregoing charger or the RX oscillating circuit of the foregoing mobile phone. Referring to FIG. 5a and FIG. 5b, the quality factor measurement circuit based on an oscillating circuit provided by this embodiment of this application includes an oscillating circuit 501, a measurement control circuit 502, and a voltage sampling circuit 503.

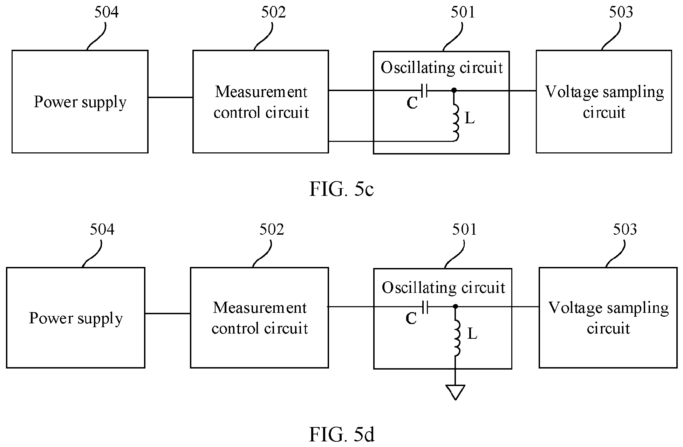

The measurement control circuit 502 is connected to a power supply 504, and the measurement control circuit 502 is connected to the oscillating circuit 501. The oscillating circuit 501 includes an inductor L and a capacitor C connected in series, where a first terminal of the inductor L is connected to the measurement control circuit 502, a second terminal of the inductor L is connected to a first terminal of the capacitor C, and a second terminal of the capacitor C is connected to a common voltage terminal (for example, a negative terminal of the power supply 504, as shown in FIG. 5b) or the measurement control circuit 502 (as shown in FIG. 5a). Another connection form of the inductor L and the capacitor C in the oscillating circuit 501 may be shown in FIG. 5c and FIG. 5d, where the second terminal of the capacitor C is connected to the measurement control circuit 502, the first terminal of the capacitor C is connected to the second terminal of the inductor L, and the first terminal of the inductor L is connected to the common voltage terminal (for example, the negative terminal of the power supply 504, as shown in FIG. 5d) or the measurement control circuit 502 (as shown in FIG. 5c).

The measurement control circuit 502 is configured to connect the inductor L and the capacitor C to the power supply 504 in series to form a charging loop to charge the capacitor C. The measurement control circuit 502 is further configured to connect the inductor L and the capacitor C to form an LC oscillating loop; or the measurement control circuit 502 is configured to connect the inductor L and the capacitor C to form an LC oscillating loop, and connect a predetermined resistor in series to the LC oscillating loop. The voltage sampling circuit 503 is connected to the first terminal of the capacitor C, and is configured to sample a voltage of the capacitor C in the LC oscillating loop formed by the inductor L and the capacitor C to obtain a first peak voltage, or sample a voltage of the capacitor C in the LC oscillating loop formed by the inductor L, the capacitor C, and the predetermined resistor to obtain a second peak voltage, where the first peak voltage and the second peak voltage are used to calculate a quality factor Q value of the inductor L.

A difference between FIG. 5a and FIG. 5b is that the second terminal of the capacitor C is directly connected to the measurement control circuit 502, or that when the measurement control circuit 502 and the oscillating circuit 501 are connected to the same common voltage terminal, the second terminal of the capacitor C may also be directly connected to the common voltage terminal.

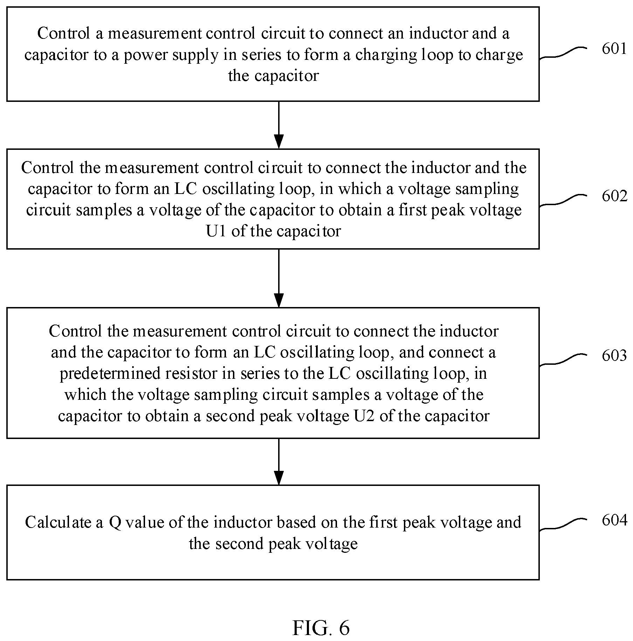

Referring to FIG. 6, a quality factor measurement method based on an oscillating circuit is provided and applied to the quality factor measurement circuit based on an oscillating circuit shown in FIG. 5. The method specifically includes the following steps.

601. Control the measurement control circuit to connect the inductor and the capacitor to the power supply in series to form a charging loop to charge the capacitor.

602. Control the measurement control circuit to connect the inductor and the capacitor to form an LC oscillating loop, in which the voltage sampling circuit samples a voltage of the capacitor to obtain a first peak voltage U1 of the capacitor.

603. Control the measurement control circuit to connect the inductor and the capacitor to form an LC oscillating loop, and connect a predetermined resistor in series to the LC oscillating loop, in which the voltage sampling circuit samples a voltage of the capacitor to obtain a second peak voltage U2 of the capacitor.

It can be understood that step 602 or 603 is selectively performed after step 601, that is, step 602 is performed after step 601, or step 603 is performed after 601. As such, step 602 is performed after the capacitor is charged for the first time, and step 603 is performed after the capacitor is charged for the second time. Certainly, step 603 is performed after the capacitor is charged for the first time, or step 602 is performed after the capacitor is charged for the second time.

604. Calculate a Q value of the inductor based on the first peak voltage and the second peak voltage.

In an example, the first peak voltage is any peak voltage of a damped oscillation voltage generated at the first terminal of the capacitor by the LC oscillating loop formed by connecting the inductor and the capacitor; and the second peak voltage is any peak voltage of a damped oscillation voltage generated at the first terminal of the capacitor by the LC oscillating loop formed by connecting the predetermined resistor, the inductor, and the capacitor, where the first peak voltage and the second peak voltage correspond to peak voltages in the same cycle of the damped oscillation voltages. For example, the first peak voltage is a peak voltage in a first cycle of its corresponding damped oscillation voltage, and the second peak voltage is also a peak voltage in a first cycle of its corresponding damped oscillation voltage. Certainly, the first peak voltage and the second peak voltage each may also be a peak voltage in a second cycle or an $N^{th}$ cycle. A higher peak voltage indicates a more accurate measurement result. Therefore, to improve the measurement accuracy, in a preferable solution, the first peak voltage is a maximum peak forward voltage of a damped oscillation voltage generated at the first terminal of the capacitor by the LC oscillating loop formed by connecting the inductor and the capacitor; and the second peak voltage is a maximum peak forward voltage of a damped oscillation voltage generated at the first terminal of the capacitor by the LC oscillating loop formed by connecting the predetermined resistor, the inductor, and the capacitor.

In this application, in step 604, specifically, an equivalent inductance value L1 of the inductor L may be calculated by using the following formula 1, and an equivalent impedance R1 of the inductor L may be calculated by using the following formula 2:

$$L1 = \frac{R^2 Cp}{4\left(\sqrt{\dfrac{(\ln U1/Us)^2}{(n*\pi)^2 + (\ln U1/Us)^2}} - \sqrt{\dfrac{(\ln U2/Us)^2}{(n*\pi)^2 + (\ln U2/Us)^2}}\right)^2} \qquad \text{formula 1;}$$

$$R1 = \frac{R}{\dfrac{\sqrt{\dfrac{(\ln U1/Us)^2}{(n*\pi)^2 + (\ln U1/Us)^2}}}{\sqrt{\dfrac{(\ln U2/Us)^2}{(n*\pi)^2 + (\ln U2/Us)^2}}} - 1} \qquad \text{formula 2;}$$

and
the Q value of the inductor is calculated based on the equivalent inductance value L1 and the equivalent impedance R1, where L1 is the equivalent inductance value of the inductor L, R1 is the equivalent impedance of the inductor L, Us is an output voltage of the power supply (Us is also a voltage value of the capacitor C when fully charged), U1 is a first sampling voltage, U2 is a second sampling voltage, R is a resistance value of the predetermined resistor, n is a positive integer, and Cp is a capacitance value of the capacitor C. Calculating the Q value of the inductor based on the equivalent inductance value L1 and the equivalent impedance R1 includes calculating the Q value of the inductor L by using the following formula 3:

$$Q = \sqrt{\frac{L1}{Cp}} * \frac{1}{R1} \qquad \qquad \text{formula 3.}$$

In the above solution, the measurement control circuit 502 can connect the inductor L and the capacitor C to the power supply 504 in series to form a charging loop to charge the capacitor C; in addition, the measurement control circuit 502 can further connect the inductor L and the capacitor C to form an LC oscillating loop; or the measurement control circuit 502 is configured to connect the inductor L and the capacitor C to form an LC oscillating loop, and connect the predetermined resistor in series to the LC oscillating loop. In this way, after the power supply charges the capacitor C, the voltage sampling circuit can sample the voltage of the capacitor C in the LC oscillating loop formed by the inductor L and the capacitor C to obtain the first peak voltage; or after the power supply charges the capacitor C, the voltage sampling circuit can sample the voltage of the capacitor C in the LC oscillating loop formed by the inductor L, the capacitor C, and the predetermined resistor to obtain the second peak voltage; and the first peak voltage and the second peak voltage can be used to calculate the quality factor Q value of the inductor L. It can be learned that according to the quality factor measurement circuit based on an oscillating circuit provided in this application, compared with the conventional technology, the sampling process of the voltage does not require a frequency sweep or a measurement of a frequency of damped oscillation of the LC oscillating loop, so as to prevent a measurement time from being limited by the frequency sweep or the frequency of the damped oscillation of the LC oscillating loop. In addition, the problem that the frequency of the damped oscillation of the LC oscillating loop is difficult to measure due to hardware limitations can be avoided, so as to obtain the Q value quickly with high precision.

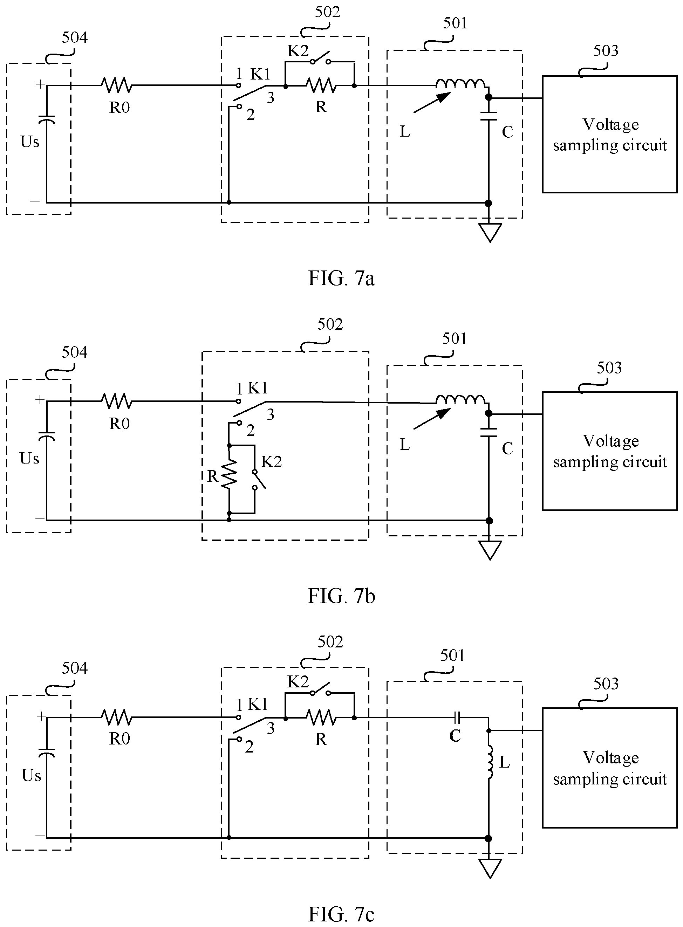

Referring to FIG. 7a, a schematic diagram of a measurement control circuit 502 is provided.
The measurement control circuit 502 includes a first switching assembly K1, a second switching assembly K2, and a predetermined resistor R. A first terminal (1) of the first switching assembly K1 is connected to a power supply 504 (as shown in FIG. 7a, to a positive terminal (+) of the power supply 504), a second terminal (2) of the first switching assembly K1 is connected to a second terminal of a capacitor C or a common voltage terminal (for example, a negative terminal of the power supply), a third terminal (3) of the first switching assembly K1 is connected to a first terminal of the predetermined resistor R, and a second terminal of the predetermined resistor R is connected to a first terminal of an inductor L. A first terminal of the second switching assembly K2 is connected to the first terminal of the predetermined resistor R, and a second terminal of the second switching assembly K2 is connected to the second terminal of the predetermined resistor R. In addition, referring to FIG. 7c, a connection manner of the inductor L and the capacitor C in an oscillating circuit 501 is different from that in FIG. 7a. In FIG. 7c, the first terminal (1) of the first switching assembly K1 is connected to the power supply 504 (as shown in FIG. 7c, to the positive terminal (+) of the power supply 504), the second terminal (2) of the first switching assembly K1 is connected to the first terminal of the inductor L or the common voltage terminal (for example, the negative terminal of the power supply), the third terminal (3) of the first switching assembly K1 is connected to the first terminal of the predetermined resistor R, and the second terminal of the predetermined resistor R is connected to the second terminal of the capacitor C. The first terminal of the second switching assembly K2 is connected to the first terminal of the predetermined resistor R, and the second terminal of the second switching assembly K2 is connected to the second terminal of the predetermined resistor R. When the first terminal of the first switching assembly K1 is connected to the third terminal of the first switching assembly K1, and the first terminal of the second switching assembly K2 is connected to the second terminal of the second switching assembly K2, the inductor L and the capacitor C are connected to the power supply 504 in series to form a charging loop to charge the capacitor C. In addition, as shown in FIG. 7a, to prevent oscillation of the charging loop, a charging resistor R0 is connected in series between the positive terminal of the power supply 504 and the first terminal of the first switching assembly K1. When the second terminal of the first switching assembly K1 is connected to the third terminal of the first switching assembly K1, and the first terminal of the second switching assembly K2 is connected to the second terminal of the second switching assembly K2, the inductor L and the capacitor C are connected to form an LC oscillating loop; and when the second terminal of the first switching assembly K1 is connected to the third terminal of the first switching assembly K1, and the first terminal of the second switching assembly K2 is disconnected from the second terminal of the second switching assembly K2, the inductor L and the capacitor C are connected to form an LC oscillating loop, and the predetermined resistor R is connected in series to the LC oscillating loop.

The first switching assembly K1 includes a single-pole double-throw relay or is formed by connecting at least two switching devices, for example, is formed by connecting two switching transistors. The second switching assembly K2 includes a switching transistor or a relay. The above-mentioned switching device or switching transistor may be a metal-oxide-semiconductor field-effect transistor (metal-oxide-semiconductor field-effect transistor, MOSFET).

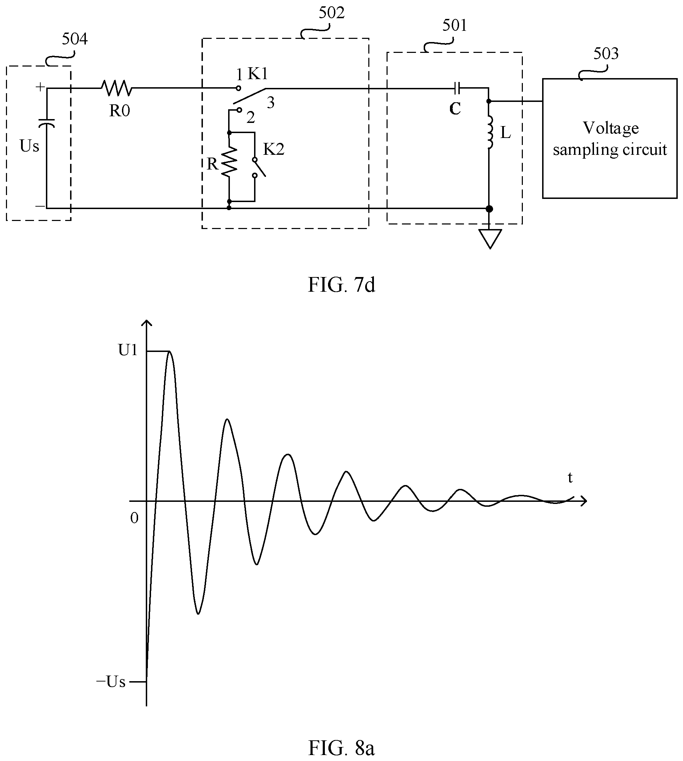

Referring to FIG. 7b, which is different from FIG. 7a, in this example, the predetermined resistor R may be connected in another position. The measurement control circuit 502 includes a first switching assembly K1, a second switching assembly K2, and the predetermined resistor R. A first terminal (1) of the first switching assembly K1 is connected to the power supply 504 (as shown in FIG. 7b, to the positive terminal (+) of the power supply 504), a second terminal (2) of the first switching assembly K1 is connected to a first terminal of the predetermined resistor R, a second terminal of the predetermined resistor R is connected to the second terminal of the capacitor C or the common voltage terminal (for example, the negative terminal of the power supply) or the measurement control circuit, and a third terminal (3) of the first switching assembly K1 is connected to the first terminal of the inductor L. A first terminal of the second switching assembly K2 is connected to the first terminal of the predetermined resistor R, and a second terminal of the second switching assembly K2 is connected to the second terminal of the predetermined resistor R. In addition, referring to FIG. 7d, a connection manner of the inductor L and the capacitor C in the oscillating circuit 501 is different from that in FIG. 7b. In FIG. 7d, the first terminal (1) of the first switching assembly K1 is connected to the power supply 504 (as shown in FIG. 7d, to the positive terminal (+) of the power supply 504), the second terminal (2) of the first switching assembly K1 is connected to the first terminal of the predetermined resistor R, the second terminal of the predetermined resistor R is connected to the first terminal of the inductor L or the common voltage terminal (for example, the negative terminal of the power supply) or the measurement control circuit, and the third terminal (3) of the first switching assembly K1 is connected to the second terminal of the capacitor C. The first terminal of the second switching assembly K2 is connected to the first terminal of the predetermined resistor R, and the second terminal of the second switching assembly K2 is connected to the second terminal of the predetermined resistor R. When the first terminal of the first switching assembly K1 is connected to the third terminal of the first switching assembly K1, the inductor L and the capacitor C are connected to the power supply 504 in series to form the charging loop to charge the capacitor C. In addition, as shown in FIG. 7b, to prevent oscillation of the charging loop, the charging resistor R0 is connected in series between the positive terminal of the power supply 504 and the first terminal of the first switching assembly K1. When the second terminal of the first switching assembly K1 is connected to the third terminal of the first switching assembly K1, and the first terminal of the second switching assembly K2 is connected to the second terminal of the second switching assembly K2, the inductor L and the capacitor C are connected to form an LC oscillating loop; and when the second terminal of the first switching assembly K1 is connected to the third terminal of the first switching assembly K1, and the first terminal of the second switching assembly K2 is disconnected from the second terminal of the second switching assembly K2, the inductor L and the capacitor C are connected to form an LC oscillating loop, and the predetermined resistor R is connected in series to the LC oscillating loop.

An embodiment of this application provides a quality factor measurement method based on an oscillating circuit, which is applied to the quality factor measurement circuit based on an oscillating circuit shown in FIG. 7a, and specifically includes the following steps.

701. Control the first terminal of the first switching assembly K1 to be connected to the third terminal of the first switching assembly K1, and the first terminal of the second switching assembly K2 to be connected to the second terminal of the second switching assembly K2; and connect the inductor L and the capacitor C to the power supply 504 in series to form a charging loop to charge the capacitor C.

When the first terminal of the first switching assembly K1 is connected to the third terminal of the first switching assembly K1, and the first terminal of the second switching assembly K2 is connected to the second terminal of the second switching assembly K2, the power supply cooperates with the first switching assembly to form a step signal, and input a voltage signal Us to the oscillating circuit.

702. Control the second terminal of the first switching assembly K1 to be connected to the third terminal of the first switching assembly K1, and the first terminal of the second switching assembly K2 to be connected to the second terminal of the second switching assembly K2; and a voltage sampling circuit 503 samples a voltage of the capacitor to obtain a first peak voltage U1 of the capacitor.

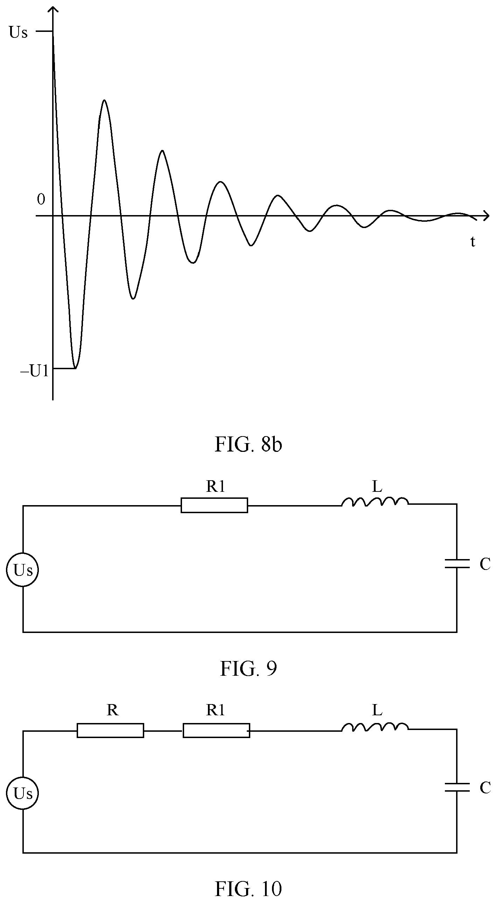

In step 701, the power supply completes charging the capacitor C. In this step, when the second terminal of the first switching assembly K1 is connected to the third terminal of the first switching assembly K1, the power supply is disconnected to stop charging the capacitor C. The inductor and the capacitor are connected to form the LC oscillating loop, and only the inductor and the capacitor are connected to the LC oscillating loop. Because the capacitor C is charged in step 701, damped oscillation occurs in a voltage of the LC oscillating loop. When the capacitor C is discharged, a voltage Uc at the first terminal of the capacitor C presents damped oscillation. The voltage sampling circuit 503 samples the voltage of the capacitor to obtain the first peak voltage of the capacitor. For example, the first peak voltage is shown in FIG. 8a, which shows the damped oscillation voltage Uc at the first terminal of the capacitor, and the first peak voltage may be a maximum peak forward voltage U1. FIG. 8b shows the damped oscillation voltage Uc at the first terminal of the capacitor, and the first peak voltage may be a maximum peak reverse voltage (-U1). It should be noted that the first peak voltage may be any peak voltage of a damped oscillation voltage generated at the first terminal of the capacitor by the LC oscillating loop formed by connecting the inductor and the capacitor. The measurement control circuit 502 may connect the inductor L and the capacitor C to the power supply 504 in series to form the charging loop, an equivalent circuit of which is shown in FIG. 9. It can be learned from the principle of damped oscillation that, an expression for an $x^{th}$ peak value after Us (-Us) is:

$$U1_x = (-1)^{x+1} * Us * e^{-(\xi1)*x*\pi/\sqrt{1-(\xi1)^2}}$$ , where $\xi1 = (R1\sqrt{Cp/L1})/2$ , representing a damping ratio of damped oscillation. When x is an odd number, $U1_x$ is a positive peak value; and when x is an even number, $U1_x$ is a negative peak value. Conversely, an expression for an $x^{th}$ peak value after Us (Us) is:

$$U1_x = (-1)^{x} * Us * e^{-(\xi2)*x*\pi/\sqrt{1-(\xi2)^2}}$$ , where $\xi2 = ((R+R1)\sqrt{Cp/L1})/2$ , representing a damping ratio of damped oscillation. When x is an odd number, $U1_x$ is a negative peak value; and when x is an even number, $U1_x$ is a positive peak value.

703. Control the first terminal of the first switching assembly K1 to be connected to the third terminal of the first switching assembly K1, and the first terminal of the second switching assembly K2 to be connected to the second terminal of the second switching assembly; and connect the inductor L and the capacitor C to the power supply 504 in series to form the charging loop to charge the capacitor C.

704. Control the second terminal of the first switching assembly K1 to be connected to the third terminal of the first switching assembly K1, and the first terminal of the second switching assembly K2 to be disconnected from the second terminal of the second switching assembly K2; and the voltage sampling circuit 503 samples the voltage of the capacitor to obtain a second peak voltage U2 of the capacitor.

In step 703, the power supply completes charging the capacitor C. In this step, when the second terminal of the first switching assembly K1 is connected to the third terminal of the first switching assembly K1, the power supply is disconnected to stop charging the capacitor C. The predetermined resistor, the inductor, and the capacitor are connected to form the LC oscillating loop, and only the predetermined resistor, the inductor, and the capacitor are connected to the LC oscillating loop. Because the capacitor C is charged in step 703, damped oscillation occurs in a voltage of the LC oscillating loop. When the capacitor C is discharged, a voltage Uc at the first terminal of the capacitor C presents damped oscillation. The voltage sampling circuit 503 samples the voltage of the capacitor to obtain the second peak voltage U2 of the capacitor. For example, the second peak voltage U2 may be the maximum peak forward voltage U2. Because the predetermined resistor is connected in series to the LC oscillating loop, an amplitude of the damped oscillation voltage at the first terminal of the capacitor is reduced compared with that in FIG. 8a or FIG. 8b. The second peak voltage may be any peak voltage of a damped oscillation voltage generated at the first terminal of the capacitor by the LC oscillating loop formed by connecting the predetermined resistor, the inductor, and the capacitor. The measurement control circuit 502 may control to connect the inductor and the capacitor to form the LC oscillating loop, and connect the predetermined resistor in series to the LC oscillating loop, an equivalent circuit of which is shown in FIG. 10. It can be learned from the principle of damped oscillation that, an expression for an $x^{th}$ peak value after Us (-Us) is:

$$U2_x = (-1)^{x+1} * Us * e^{-(\xi2)*x*\pi/\sqrt{1-(\xi2)^2}}$$ , where $\xi2 = ((R+R1)\sqrt{Cp/L1})/2$ , representing a damping ratio of damped oscillation. When x is an odd number, $U2_x$ is a positive peak value; and when x is an even number, $U2_x$ is a negative peak value. Conversely, an expression for an $x^{th}$ peak value after Us (Us) is:

$$U2_x = (-1)^{x} * Us * e^{-(\xi2)*x*\pi/\sqrt{1-(\xi2)^2}}$$ , where $\xi2 = ((R+R1)\sqrt{Cp/L1})/2$ , representing a damping ratio of damped oscillation. When x is an odd number, $U2_x$ is a negative peak value; and when x is an even number, $U2_x$ is a positive peak value.

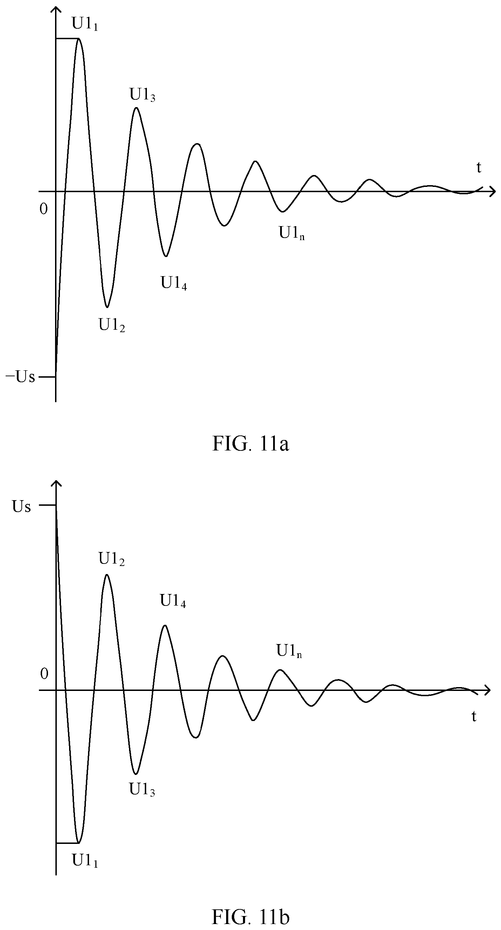

In steps 702 and 703, the first peak voltage U1 and the second peak voltage U2 may correspond to peak voltages in the same cycle of the damped oscillation voltages. Therefore, referring to FIG. 11a and FIG. 11b, for example, the first peak voltage U1 (-U1) may be the first peak voltage after Us in its corresponding damped oscillation voltage, for example, a peak voltage $U1_1$ in a first cycle in FIG. 11a and FIG. 11b. Certainly, the first peak voltage U1 may also be a peak voltage $U1_n$ in a second cycle or an $N^{th}$ cycle. Similarly, the second peak voltage U2 may be a peak voltage in the same cycle as the first peak voltage U1. n in the foregoing formula 1 and formula 2 represents an $n^{th}$ peak value after the peak value Us and is a positive integer. When n is 1, a value of U1 is $U1_1$, and a value of U2 is $U2_1$.

705. Calculate a Q value of the inductor based on the first peak voltage and the second peak voltage.

For a specific manner of this step, refer to the foregoing example, and details are not described herein again.

An embodiment of this application provides a quality factor measurement method based on an oscillating circuit, which is applied to the quality factor measurement circuit based on an oscillating circuit shown in FIG. 7b, and specifically includes the following steps.

801. Control the first terminal of the first switching assembly K1 to be connected to the third terminal of the first switching assembly K1; and connect the inductor L and the capacitor C to the power supply 504 in series to form a charging loop to charge the capacitor C.

When the first terminal of the first switching assembly K1 is connected to the third terminal of the first switching assembly K1, the power supply cooperates with the first switching assembly to form a step signal, and input a voltage signal Us to the oscillating circuit.

802. Control the second terminal of the first switching assembly K1 to be connected to the third terminal of the first switching assembly K1, and the first terminal of the second switching assembly K2 to be connected to the second terminal of the second switching assembly K2; and a voltage sampling circuit 503 samples a voltage of the capacitor to obtain a first peak voltage U1 of the capacitor.

For a specific description of this step, refer to the description of step 702, and details are not described herein again.

803. Control the first terminal of the first switching assembly K1 to be connected to the third terminal of the first switching assembly K1; and connect the inductor L and the capacitor C to the power supply 504 in series to form the charging loop to charge the capacitor C.

804. Control the second terminal of the first switching assembly K1 to be connected to the third terminal of the first switching assembly K1, and the first terminal of the second switching assembly K2 to be disconnected from the second terminal of the second switching assembly K2; and the voltage sampling circuit 503 samples the voltage of the capacitor to obtain a second peak voltage U2 of the capacitor.

For a specific description of this step, refer to the description of step 704, and details are not described herein again.

805. Calculate a Q value of the inductor based on the first peak voltage and the second peak voltage.

For a specific manner of this step, refer to the foregoing example, and details are not described herein again.

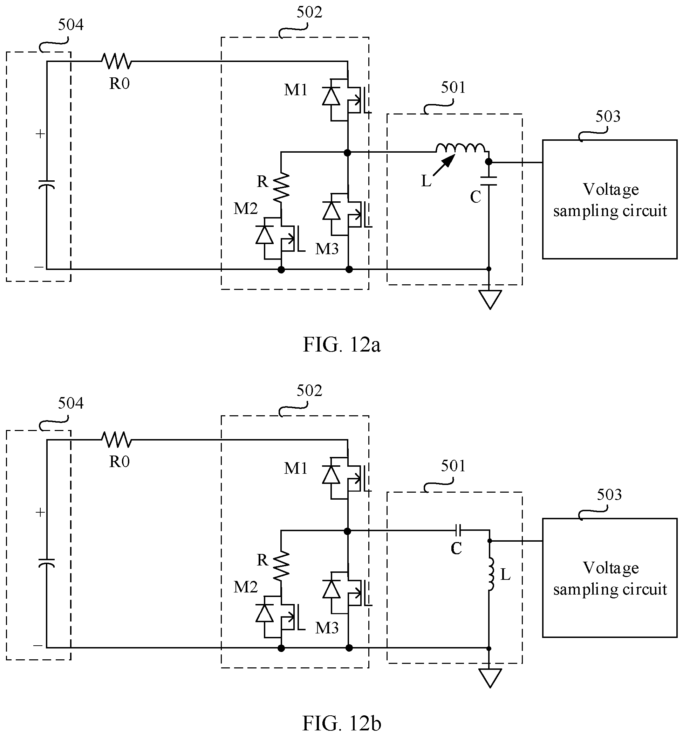

In another example, referring to FIG. 12a, the measurement control circuit 502 includes a first switching assembly M1, a second switching assembly M2, a third switching assembly M3, and the predetermined resistor R.

A first terminal of the first switching assembly M1 is connected to the power supply 504 (for example, to the positive terminal (+) of the power supply 504), and a second terminal of the first switching assembly M1 is connected to the first terminal of the inductor L. A first terminal of the predetermined resistor R is connected to the second terminal of the first switching assembly M1, and a second terminal of the predetermined resistor R is connected to a first terminal of the second switching assembly M2. A first terminal of the third switching assembly M3 is connected to the second terminal of the first switching assembly M1, and a second terminal of the second switching assembly M2 and a second terminal of the third switching assembly M3 are connected to the second terminal of the capacitor C or the common voltage terminal (for example, the negative terminal (-) of the power supply 504). In addition, referring to FIG. 12b, a connection manner of the inductor L and the capacitor C in the oscillating circuit 501 in FIG. 12b is different from that in FIG. 12a. The first terminal of the first switching assembly M1 is connected to the power supply 504 (for example, the positive terminal (+) of the power supply 504), and the second terminal of the first switching assembly M1 is connected to the second terminal of the capacitor C. The first terminal of the predetermined resistor R is connected to the second terminal of the first switching assembly M1, and the second terminal of the predetermined resistor R is connected to the first terminal of the second switching assembly M2. The first terminal of the third switching assembly M3 is connected to the second terminal of the first switching assembly M1, and the second terminal of the second switching assembly M2 and the second terminal of the third switching assembly M3 are connected to the first terminal of the inductor L or the common voltage terminal (for example, the negative terminal (-) of the power supply 504). When the first terminal of the first switching assembly M1 is connected to the second terminal of the first switching assembly M1, the first terminal of the second switching assembly M2 is disconnected from the second terminal of the second switching assembly M2, and the first terminal of the third switching assembly M3 is disconnected from the second terminal of the third switching assembly M3, the inductor L and the capacitor C are connected to the power supply 504 in series to form the charging loop to charge the capacitor C; when the first terminal of the first switching assembly M1 is disconnected from the second terminal of the first switching assembly M1, the first terminal of the second switching assembly M2 is disconnected from or connected to the second terminal of the second switching assembly M2, and the first terminal of the third switching assembly M3 is connected to the second terminal of the third switching assembly M3, the inductor L and the capacitor C are connected to form the LC oscillating loop; and when the first terminal of the first switching assembly M1 is disconnected from the second terminal of the first switching assembly M1, the first terminal of the second switching assembly M2 is connected to the second terminal of the second switching assembly M2, and the first terminal of the third switching assembly M3 is disconnected from the second terminal of the third switching assembly M3, the inductor L and the capacitor C are connected to form the LC oscillating loop, and the predetermined resistor R is connected in series to the LC oscillating loop. For example, the first switching assembly, the second switching assembly, and the third switching assembly are relays or switching transistors.

An embodiment of this application provides a quality factor measurement method based on an oscillating circuit, which is applied to the quality factor measurement circuits based on an oscillating circuit shown in FIG. 12a and FIG. 12b, and specifically includes the following steps.

901. Control the first terminal of the first switching assembly M1 to be connected to the second terminal of the first switching assembly M1, the first terminal of the second switching assembly M2 to be disconnected from the second terminal of the second switching assembly M2, and the first terminal of the third switching assembly M3 to be disconnected from the second terminal of the third switching assembly M3; and connect the inductor and the capacitor to the power supply in series to form a charging loop to charge the capacitor C.

902. Control the first terminal of the first switching assembly M1 to be disconnected from the second terminal of the first switching assembly M1, the first terminal of the second switching assembly M2 to be disconnected from or connected to the second terminal of the second switching assembly, and the first terminal of the third switching assembly M3 to be connected to the second terminal of the third switching assembly; and a voltage sampling circuit samples a voltage of the capacitor to obtain a first peak voltage of the capacitor.

903. Control the first terminal of the first switching assembly M1 to be connected to the second terminal of the first switching assembly M1, the first terminal of the second switching assembly M2 to be disconnected from the second terminal of the second switching assembly M2, and the first terminal of the third switching assembly M3 to be disconnected from the second terminal of the third switching assembly M3; and connect the inductor and the capacitor to the power supply in series to form the charging loop to charge the capacitor.

904. Control the first terminal of the first switching assembly M1 to be disconnected from the second terminal of the first switching assembly M1, the first terminal of the second switching assembly M2 to be connected to the second terminal of the second switching assembly M2, and the first terminal of the third switching assembly M3 to be disconnected from the second terminal of the third switching assembly M3; and the voltage sampling circuit samples the voltage of the capacitor to obtain a second peak voltage of the capacitor.

905. Calculate a Q value of the inductor based on the first peak voltage and the second peak voltage.

The specific principle of steps 901 to 905 is similar to that of steps 701 to 705. For details, refer to the foregoing description, which is not described herein again.

In addition, the measurement control circuit 502 further includes a fourth switching assembly M4. When the fourth switching assembly M4 is used in FIG. 12a, a first terminal of the fourth switching assembly M4 is connected to the second terminal of the capacitor C, and a second terminal of the fourth switching assembly M4 is connected to the common voltage terminal or the measurement control circuit 502. Alternatively, when the fourth switching assembly M4 is used in FIG. 12b, the first terminal of the fourth switching assembly M4 is connected to the first terminal of the inductor L, and the second terminal of the fourth switching assembly M4 is connected to the common voltage terminal or the measurement control circuit 502. Certainly, when the measurement control circuit 502 includes the fourth switching assembly M4, it is required to control M4 to be in a connected state in all of the foregoing steps 901 to 904.

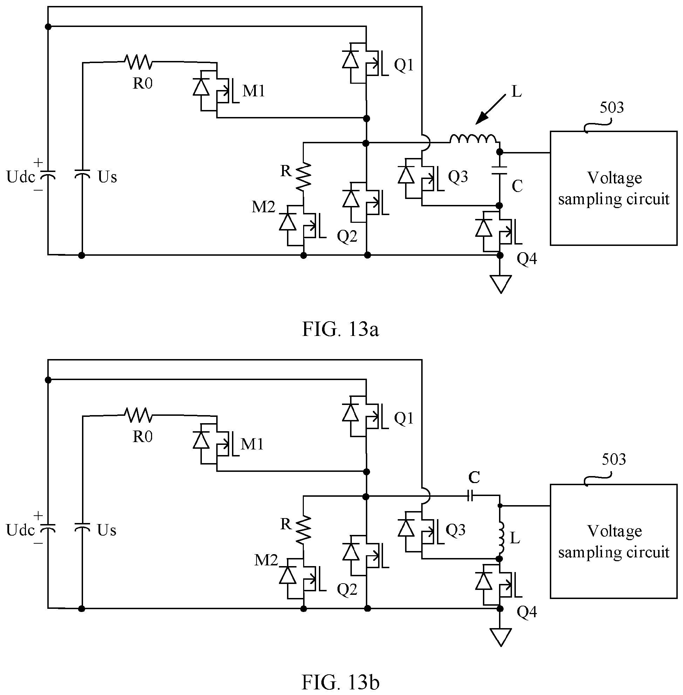

It should be noted that, to reduce circuit costs, when the quality factor measurement circuit based on an oscillating circuit shown in FIG. 12a or FIG. 12b is used in the charger, the third switching assembly M3 can reuse the switching transistor Q2 of the lower bridge arm in the first bridge in FIG. 4; in addition, the fourth switching assembly M4 can reuse the switching transistor Q4 of the lower bridge arm in the second bridge in FIG. 4 to be connected to the negative terminal (-) of the power supply. In other words, as shown in FIG. 13a or FIG. 13b, M1, M2, R0, and R are added directly on the basis of FIG. 4. For a connection relationship between M1, M2, R0, and R, refer to the specific description in FIG. 12a and FIG. 12b, and details are not described herein again. Certainly, when the quality factor measurement circuit based on an oscillating circuit includes the switching transistor Q4, it is required to control Q4 to be in a connected state in all of the foregoing steps 901 to 904. In addition, it should be noted that the quality factor measurement circuit based on an oscillating circuit provided in this embodiment of this application may use the same source as or a different source from the wireless charging circuit provided in FIG. 4. As shown in FIG. 13a or FIG. 13b, when they use different sources, the quality factor measurement circuit based on an oscillating circuit uses a voltage source Us, and the wireless charging circuit uses a voltage source Udc. A connection manner of the inductor L and the capacitor C in the oscillating circuit 501 in FIG. 13a is different from that in FIG. 13b. Refer to the description of the foregoing example, and details are not described herein again.

In addition, the voltage sampling circuit includes any one of the following: a voltage follower circuit, a peak voltage sampling circuit, a cycle-by-cycle peak voltage sampling circuit, and a voltage attenuation detection circuit.

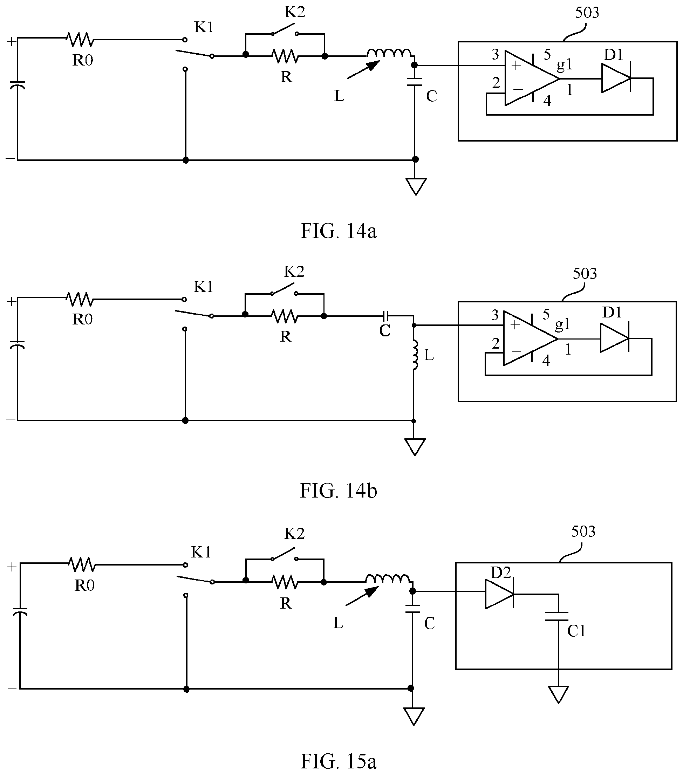

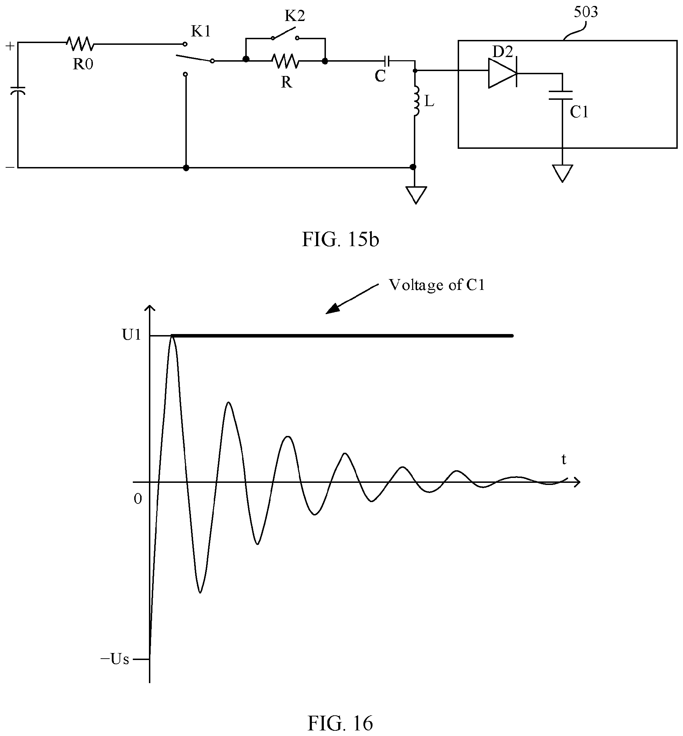

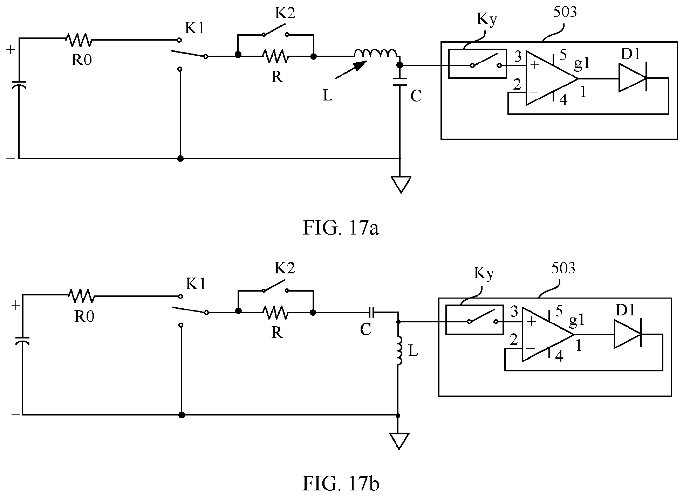

As shown in FIG. 14a and FIG. 14b, schematic diagrams of a voltage sampling circuit are provided. The voltage sampling circuit is a voltage follower circuit. The voltage follower circuit includes a voltage follower g1 and a diode D1. Because voltages are equal at a terminal 3 and a terminal 1 of the voltage follower g1, the diode D1 may be connected to the terminal 1 of g1 to sample a peak voltage of the capacitor C. As shown in FIG. 15a and FIG. 15b, schematic diagrams of another voltage sampling circuit are provided. The voltage sampling circuit is a peak voltage sampling circuit. The peak voltage sampling circuit includes a diode D2 and C1. Due to the one-direction conduction function of the diode D2 and the energy storage function of the capacitor C1, a voltage value on C1 is kept at a peak voltage with a damped oscillation voltage output on the first terminal of the capacitor C. As shown in FIG. 16, a curve of the damped oscillation voltage on the first terminal of the capacitor C and the voltage of C1 are provided, and it can be learned that the voltage on C1 is stabilized at the peak voltage U1. When the voltage sampling circuit is a cycle-by-cycle peak voltage sampling circuit, as shown in FIG. 17a and FIG. 17b, the cycle-by-cycle peak voltage sampling circuit is configured to successively collect a peak in each cycle of the damped oscillation voltage. Therefore, U1 may also be a peak voltage in a first cycle of the curve of the damped oscillation voltage collected by the cycle-by-cycle peak voltage sampling circuit, or may also be a peak voltage in a second or even $N^{th}$ cycle of the curve of the damped oscillation voltage. Different from FIG. 14a and FIG. 14b, the cycle-by-cycle peak voltage sampling circuit shown in FIG. 17a and FIG. 17b further includes a delay switch Ky connected to the terminal 3 of the voltage follower g1. The delay switch Ky may be turned on at different delays to connect the first terminal of the capacitor C to the terminal 3 of the voltage follower g1, so as to collect the peak in each cycle of the damped oscillation voltage. A connection manner of the inductor L and the capacitor C in the oscillating circuit 501 in FIG. 14a, FIG. 15a, and FIG. 17a is different from that in FIG. 14b, FIG. 15b, and FIG. 17b, respectively. Refer to the description of the foregoing example, and details are not described herein again.

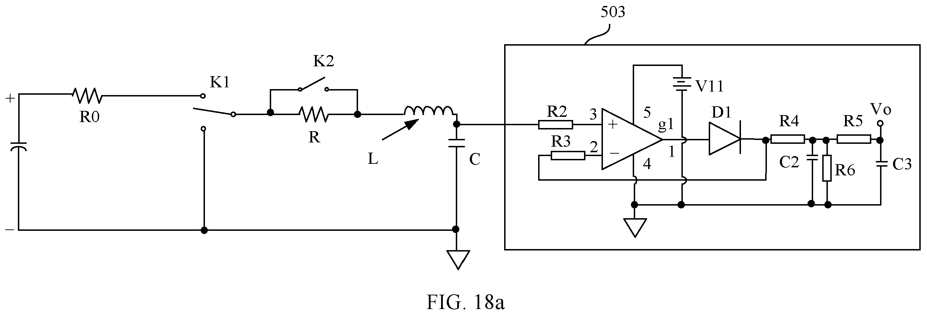

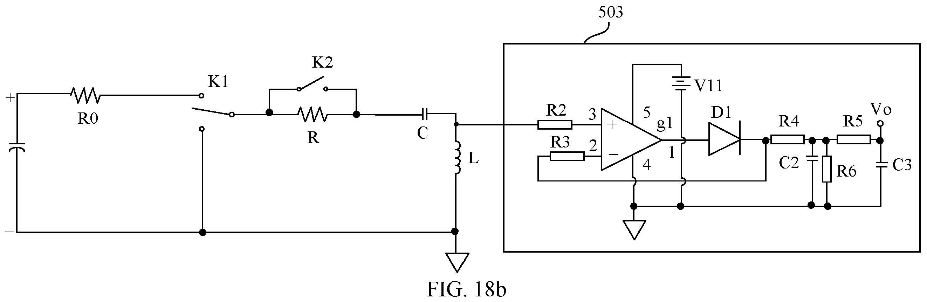

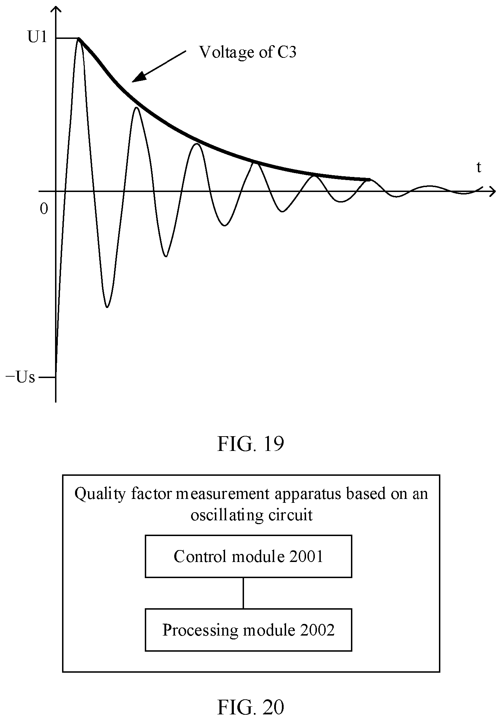

As shown in FIG. 18a and FIG. 18b, schematic diagrams of anothervoltage sampling circuit are provided. The voltage sampling circuit is a voltage attenuation detection circuit. The voltage attenuation detection circuit includes: a voltage follower g1, resistors R2 to R6, a diode D1, and capacitors C2 and C3. A terminal 4 of the voltage follower g1 is connected to a negative terminal (-) of a power supply V11, a terminal 5 is connected to a positive terminal (+) of the power supply V11, a terminal 3 is connected to the first terminal of the capacitor C via the resistor R2, a terminal 1 is connected to an anode of the diode D1, a cathode of the diode D1 is connected to a terminal 2 of the voltage follower g1 via the resistor R3, the cathode of the diode D1 is also connected to a first terminal of the resistor R4, a second terminal of R4 is connected to the negative terminal (-) of the power supply V11 via the capacitor C2, the second terminal of R4 is connected to the negative terminal (-) of the power supply V11 via the resistor R6, the second terminal of R4 is connected to a first terminal of the resistor R5, and a second terminal of R5 is connected to the negative terminal (-) of the power supply V11 via the capacitor C3. A voltage of the capacitor C3 can be sampled by using the second terminal (Vo) of R5. The voltage of the capacitor C3 is an attenuation curve of the damped oscillation voltage of the capacitor C. As shown in FIG. 19, it can be learned that a maximum voltage on C3 is a peak voltage U1. A connection manner of the inductor L and the capacitor C in the oscillating circuit 501 in FIG. 18a is different from that in FIG. 18b. Refer to the description of the foregoing example, and details are not described herein again.

Certainly, the voltage sampling circuits shown in FIG. 14a, FIG. 14b, FIG. 15a, FIG. 15b, FIG. 17a, FIG. 17b, FIG. 18a, and FIG. 18b include only the necessary components to explain the circuit principle. In some solutions, there may also be other peripheral components. In addition, a circuit in each of FIG. 14a, FIG. 14b, FIG. 15a, FIG. 15b, FIG. 17a, FIG. 17b, FIG. 18a, and FIG. 18b other than the part of the voltage sampling circuit is described by using the circuit in the schematic diagram in FIG. 7a (FIG. 7b, FIG. 7c, and FIG. 7d) as an example. In an embodiment, the circuit in each of FIG. 14a, FIG. 14b, FIG. 15a, FIG. 15b, FIG. 17a, FIG. 17b, FIG. 18a, and FIG. 18b other than the part of the voltage sampling circuit may also be replaced by the circuit shown in FIG. 12a, FIG. 12b, FIG. 13a, or FIG. 13b.

It can be understood that the quality factor measurement methods based on an oscillating circuit provided in the foregoing embodiments may be implemented by a quality factor measurement apparatus based on an oscillating circuit, and the foregoing methods and/or steps may also be implemented by a component (such as a chip or a circuit) that can be used as the quality factor measurement apparatus based on an oscillating circuit.

It can be understood that, to implement the foregoing functions, the quality factor measurement apparatus based on an oscillating circuit includes corresponding hardware structures and/or software modules for performing the functions. A person skilled in the art should easily be aware that, in combination with units and algorithm steps of the examples described in embodiments disclosed in this application, this application can be implemented by hardware or a combination of hardware and computer software. Whether a specific function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the quality factor measurement apparatus based on an oscillating circuit may be divided into functional modules based on the foregoing method embodiments. For example, each functional module may be obtained through division based on each corresponding function, or two or more functions may be integrated into one processing module. The integrated module may be implemented in a form of hardware, or may be implemented in a form of a software function module. It should be noted that, in embodiments of this application, division into the modules is an example, and is merely a logical function division. In actual implementation, another division manner may be used.

FIG. 20 is a schematic diagram of a structure of a quality factor measurement apparatus based on an oscillating circuit. The quality factor measurement apparatus based on an oscillating circuit includes a control module 2001 and a processing module 2002.

The control module 2001 is configured to control the measurement control circuit to connect the inductor and the capacitor to the power supply in series to form a charging loop to charge the capacitor.

The control module 2001 is further configured to: control the measurement control circuit to connect the inductor and the capacitor to form an LC oscillating loop, in which the voltage sampling circuit samples a voltage of the capacitor to obtain a first peak voltage of the capacitor; or control the measurement control circuit to connect the inductor and the capacitor to form an LC oscillating loop, and connect a predetermined resistor in series to the LC oscillating loop, in which the voltage sampling circuit samples a voltage of the capacitor to obtain a second peak voltage of the capacitor.

The processing module 2002 is configured to calculate a Q value of the inductor based on the first peak voltage and the second peak voltage obtained by the voltage sampling circuit.

Optionally, the measurement control circuit includes a first switching assembly, a second switching assembly, and the predetermined resistor; a first terminal of the first switching assembly is connected to the power supply, a second terminal of the first switching assembly is connected to the common voltage terminal or the second terminal of the capacitor, a third terminal of the first switching assembly is connected to a first terminal of the predetermined resistor, and a second terminal of the predetermined resistor is connected to the first terminal of the inductor; and a first terminal of the second switching assembly is connected to the first terminal of the predetermined resistor, and a second terminal of the second switching assembly is connected to the second terminal of the predetermined resistor; or the first terminal of the first switching assembly is connected to the power supply, the second terminal of the first switching assembly is connected to the common voltage terminal or the first terminal of the inductor, the third terminal of the first switching assembly is connected to the first terminal of the predetermined resistor, and the second terminal of the predetermined resistor is connected to the second terminal of the capacitor; and the first terminal of the second switching assembly is connected to the first terminal of the predetermined resistor, and the second terminal of the second switching assembly is connected to the second terminal of the predetermined resistor, where the control module 2001 is specifically configured to control the first terminal of the first switching assembly to be connected to the third terminal of the first switching assembly, and the first terminal of the second switching assembly to be connected to the second terminal of the second switching assembly; the control module 2001 is specifically configured to control the second terminal of the first switching assembly to be connected to the third terminal of the first switching assembly, and the first terminal of the second switching assembly to be connected to the second terminal of the second switching assembly; and the control module is specifically configured to control the second terminal of the first switching assembly to be connected to the third terminal of the first switching assembly, and the first terminal of the second switching assembly to be disconnected from the second terminal of the second switching assembly.

Optionally, the measurement control circuit includes a first switching assembly, a second switching assembly, and the predetermined resistor; a first terminal of the first switching assembly is connected to the power supply, a second terminal of the first switching assembly is connected to a first terminal of the predetermined resistor, a second terminal of the predetermined resistor is connected to the common voltage terminal or the second terminal of the capacitor, and a third terminal of the first switching assembly is connected to the first terminal of the inductor; and a first terminal of the second switching assembly is connected to the first terminal of the predetermined resistor, and a second terminal of the second switching assembly is connected to the second terminal of the predetermined resistor; or the first terminal of the first switching assembly is connected to the power supply, the second terminal of the first switching assembly is connected to the first terminal of the predetermined resistor, the second terminal of the predetermined resistor is connected to the common voltage terminal or the first terminal of the inductor, and the third terminal of the first switching assembly is connected to the second terminal of the capacitor; and the first terminal of the second switching assembly is connected to the first terminal of the predetermined resistor, and the second terminal of the second switching assembly is connected to the second terminal of the predetermined resistor, where the control module 2001 is specifically configured to control the first terminal of the first switching assembly to be connected to the third terminal of the first switching assembly; the control module 2001 is specifically configured to control the second terminal of the first switching assembly to be connected to the third terminal of the first switching assembly, and the first terminal of the second switching assembly to be connected to the second terminal of the second switching assembly; and the control module 2001 is specifically configured to control the second terminal of the first switching assembly to be connected to the third terminal of the first switching assembly, and the first terminal of the second switching assembly to be disconnected from the second terminal of the second switching assembly.

Optionally, the measurement control circuit includes a first switching assembly, a second switching assembly, a third switching assembly, and the predetermined resistor; a first terminal of the first switching assembly is connected to the power supply, and a second terminal of the first switching assembly is connected to the first terminal of the inductor; a first terminal of the predetermined resistor is connected to the second terminal of the first switching assembly, and a second terminal of the predetermined resistor is connected to a first terminal of the second switching assembly; and a first terminal of the third switching assembly is connected to the second terminal of the first switching assembly, and a second terminal of the second switching assembly and a second terminal of the third switching assembly are connected to the common voltage terminal or the second terminal of the capacitor C; or the first terminal of the first switching assembly is connected to the power supply, and the second terminal of the first switching assembly is connected to the second terminal of the capacitor; the first terminal of the predetermined resistor is connected to the second terminal of the first switching assembly, and the second terminal of the predetermined resistor is connected to the first terminal of the second switching assembly; and the first terminal of the third switching assembly is connected to the second terminal of the first switching assembly, and the second terminal of the second switching assembly and the second terminal of the third switching assembly are connected to the common voltage terminal or the first terminal of the inductor, where the control module 2001

is specifically configured to control the first terminal of the first switching assembly to be connected to the second terminal of the first switching assembly, the first terminal of the second switching assembly to be disconnected from the second terminal of the second switching assembly, and the first terminal of the third switching assembly to be disconnected from the second terminal of the third switching assembly; the control module 2001 is specifically configured to control the first terminal of the first switching assembly to be disconnected from the second terminal of the first switching assembly, the first terminal of the second switching assembly to be disconnected from or connected to the second terminal of the second switching assembly, and the first terminal of the third switching assembly to be connected to the second terminal of the third switching assembly; and the control module 2001 is specifically configured to control the first terminal of the first switching assembly to be disconnected from the second terminal of the first switching assembly, the first terminal of the second switching assembly to be connected to the second terminal of the second switching assembly, and the first terminal of the third switching assembly to be disconnected from the second terminal of the third switching assembly.

Optionally, the measurement control circuit further includes a fourth switching assembly; a first terminal of the fourth switching assembly is connected to the second terminal of the capacitor, and a second terminal of the fourth switching assembly is connected to the common voltage terminal or the measurement control circuit; or the first terminal of the fourth switching assembly is connected to the first terminal of the inductor, and the second terminal of the fourth switching assembly is connected to the common voltage terminal or the measurement control circuit, where the control module 2001 is specifically configured to control the first terminal of the first switching assembly to be connected to the second terminal of the first switching assembly, the first terminal of the second switching assembly to be disconnected from the second terminal of the second switching assembly, the first terminal of the third switching assembly to be disconnected from the second terminal of the third switching assembly, and the first terminal of the fourth switching assembly to be connected to the second terminal of the fourth switching assembly; the control module 2001 is specifically configured to control the first terminal of the first switching assembly to be disconnected from the second terminal of the first switching assembly, the first terminal of the second switching assembly to be disconnected from or connected to the second terminal of the second switching assembly, the first terminal of the third switching assembly to be connected to the second terminal of the third switching assembly, and the first terminal of the fourth switching assembly to be connected to the second terminal of the fourth switching assembly; and the control module 2001 is specifically configured to control the first terminal of the first switching assembly to be disconnected from the second terminal of the first switching assembly, the first terminal of the second switching assembly to be connected to the second terminal of the second switching assembly, the first terminal of the third switching assembly to be disconnected from the second terminal of the third switching assembly, and the first terminal of the fourth switching assembly to be connected to the second terminal of the fourth switching assembly.

Optionally, the processing module 2002 is specifically configured to calculate an equivalent inductance value of the inductor by using the following formula 1, and calculate an equivalent impedance of the inductor by using the following formula 2:

$$L1 = \frac{R^2 Cp}{4\left(\sqrt{\dfrac{(\ln U1/Us)^2}{(n*\pi)^2+(\ln U1/Us)^2}} - \sqrt{\dfrac{(\ln U2/Us)^2}{(n*\pi)^2+(\ln U2/Us)^2}}\right)^2} \qquad \text{formula 1;}$$

$$R1 = \frac{R}{\dfrac{\sqrt{\dfrac{(\ln U1/Us)^2}{(n*\pi)^2+(\ln U1/Us)^2}}}{\sqrt{\dfrac{(\ln U2/Us)^2}{(n*\pi)^2+(\ln U2/Us)^2}}} - 1} \qquad \text{formula 2;}$$

and

calculate the Q value of the inductor based on the equivalent inductance value and the equivalent impedance, where L1 is the equivalent inductance value of the inductor, R1 is the equivalent impedance of the inductor, Us is an output voltage of the power supply, U1 is the first sampling voltage, U2 is the second sampling voltage, R is a resistance value of the predetermined resistor, and Cp is a capacitance value of the capacitor.

Optionally, the processing module 2002 is specifically configured to calculate the Q value of the inductor by using the following formula 3:

$$Q = \sqrt{\frac{L1}{Cp}} * \frac{1}{R1}$$

formula 3.

All related content of the steps in the foregoing method embodiments may be cited in function descriptions of corresponding function modules. Details are not described herein again.

In this embodiment, the quality factor measurement apparatus based on an oscillating circuit is presented in the form of functional modules divided in an integrated manner. "Module" herein may indicate a specific ASIC, a circuit, a processor and a memory that execute one or more software or firmware programs, an integrated logic circuit, and/or another device that can provide the foregoing function.

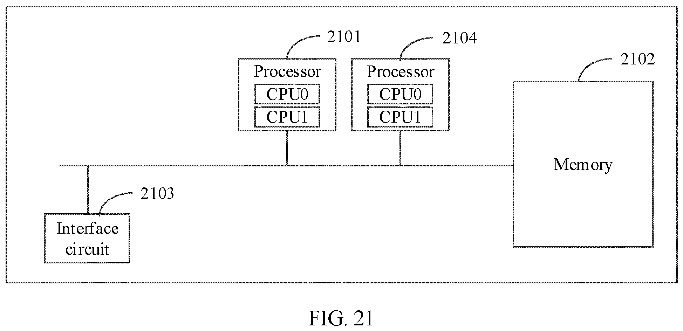

FIG. 21 is a schematic diagram of a hardware structure of a quality factor measurement apparatus based on an oscillating circuit according to an embodiment of this application.

The quality factor measurement apparatus based on an oscillating circuit includes at least one processor (for example, FIG. 21 includes one processor 2101 for illustration) and at least one interface circuit 2103 (for example, FIG. 21 includes one interface circuit 2103 for illustration). Optionally, the quality factor measurement apparatus based on an oscillating circuit may further include at least one memory (for example, FIG. 21 includes one memory 2102 for illustration).

The processor 2101, the memory 2102, and the interface circuit 2103 are connected through a communications line. The communications line may include a path transmitting information between the foregoing components.

The processor 2101 may be a general-purpose central processing unit (central processing unit, CPU), a microprocessor, an application-specific integrated circuit (application-specific integrated circuit, ASIC), or one or more integrated circuits configured to control program execution of the solutions in this application. In a specific implementation, in an embodiment, the processor 2101 may also include a plurality of CPUs, and the processor 2101 may be a single-core (single-CPU) processor or a multi-core (multi-CPU) processor. The processor herein may refer to one or more devices, circuits, or processing cores configured to process data (for example, computer program instructions).

The memory 2102 may be an apparatus having a storage function. For example, it may be a read-only memory (read-only memory, ROM), another type of static storage device that can store static information and instructions, a random access memory (random access memory, RAM), or another type of dynamic storage device that can store information and instructions; or may be an electrically erasable programmable read-only memory (electrically erasable programmable read-only memory, EEPROM), a compact disc read-only memory (compact disc read-only memory, CD-ROM) or another optical disk storage, an optical disc storage (including a compact optical disc, a laser disc, an optical disc, a digital versatile disc, a Blu-ray disc, or the like), a magnetic disk storage medium or another magnetic storage device, or any other medium that can be configured to carry or store expected program code in a form of an instruction or a data structure and that can be accessed by a computer. However, this does not constitute a limitation herein. The memory 2102 may exist independently and is connected to the processor 2101 through the communications line. The memory 2102 may alternatively be integrated with the processor 2101.

The memory 2102 is configured to store computer-executable instructions for performing the solutions in this application, and the processor 2101 controls execution of the computer-executable instructions. Specifically, the processor 2101 is configured to execute the computer-executable instructions stored in the memory 2102, to implement the quality factor measurement method based on an oscillating circuit described in embodiments of this application.

Alternatively, optionally, in the embodiments of this application, the processor 2101 may perform processing related functions in the quality factor measurement method based on an oscillating circuit provided in the following embodiment of this application, and the interface circuit 2103 is responsible for connection to the other components to implement signal transmission, for example, the control of the various switching assemblies, which may be a control signal for closing or opening the switching assemblies in the measurement control circuit; for another example, transmission of a peak voltage generated by the voltage sampling circuit. This is not specifically limited in this embodiment of this application.

Optionally, the computer-executable instructions in this embodiment of this application may also be referred to as application program code or computer program code. This is not specifically limited in this embodiment of this application.

During specific implementation, in an embodiment, the processor 2101 may include one or more CPUs, for example, a CPU 0 and a CPU 1 in FIG. 21.

During specific implementation, in an embodiment, the quality factor measurement apparatus based on an oscillating circuit may include a plurality of processors, for example, the processor 2101 and a processor 2104 in FIG. 21. Each of the processors may be a single-core (single-CPU) processor, or may be a multi-core (multi-CPU) processor. The processor herein may be one or more devices, circuits, and/or processing cores configured to process data (for example, computer program instructions).

For example, the processor 2101 in the quality factor measurement apparatus based on an oscillating circuit shown in FIG. 21 may invoke the computer-executable instructions stored in the memory 2102, to cause the quality factor measurement apparatus based on an oscillating circuit to perform the method in the foregoing method embodiment.

Specifically, the functions/implementation processes of the control module 2001 and the processing module 2002 in FIG. 20 may be implemented by the processor 2101 in the quality factor measurement apparatus based on an oscillating circuit shown in FIG. 21 invoking the computer-executable instructions stored in the memory 2102. The quality factor measurement apparatus based on an oscillating circuit provided in this embodiment may perform the foregoing method. Therefore, for technical effects that can be achieved by the apparatus, refer to the foregoing method embodiment, and details are not described herein again.

Optionally, an embodiment of this application further provides a quality factor measurement apparatus based on an oscillating circuit (for example, the quality factor measurement apparatus based on an oscillating circuit may be a chip or a chip system). The quality factor measurement apparatus based on an oscillating circuit includes a processor, to implement the method in any one of the foregoing method embodiments. In a possible design, the quality factor measurement apparatus based on an oscillating circuit further includes a memory. The memory is configured to store necessary program instructions and data, and the processor may invoke the program code stored in the memory to instruct the quality factor measurement apparatus based on an oscillating circuit to perform the method in any one of the foregoing method embodiments. Certainly, alternatively, the memory may not be included in the quality factor measurement apparatus based on an oscillating circuit. When the quality factor measurement apparatus based on an oscillating circuit is a chip system, the chip system may include a chip, or may include the chip and other discrete devices. This is not specifically limited in this embodiment of this application.

In addition, an embodiment of this application provides an electronic device, including: the quality factor measurement circuit based on an oscillating circuit and the quality factor measurement apparatus based on an oscillating circuit described above, where the electronic device may be a transmitter device or a receiver device.

All or some of the foregoing embodiments may be implemented by using software, hardware, firmware, or any combination thereof. When a software program is used to implement embodiments, all or some of the embodiments may be implemented in a form of a computer program product. The computer program product includes one or more computer instructions. When computer program instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium, or may be transmitted from one computer-readable storage medium to another computer-readable storage medium. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (solid state disk, SSD)), or the like. In embodiments of this application, the computer may include the foregoing apparatus.

Although this application is described with reference to embodiments, in a process of implementing this application that claims protection, a person skilled in the art may understand and implement another variation of the disclosed embodiments by viewing the accompanying drawings, disclosed content, and the accompanying claims. In the claims, the term "comprising" (comprising) does not exclude another component or another step, and "a" or "an" does not exclude a case of a plurality. A single processor or another unit may implement several functions enumerated in the claims. Some measures are recorded in dependent claims that are different from each other, but this does not mean that these measures cannot be combined to produce a great effect.

## Claims

1.   A quality factor measurement circuit based on an oscillating circuit (201, 301-303, 501), comprising: the oscillating circuit (201, 301-303, 501), a measurement control circuit (502), and a voltage sampling circuit (503), wherein the measurement control circuit (502) is connected to a power supply (40, 504), and the measurement control circuit (502) is connected to the oscillating circuit (201, 301-303, 501); and the oscillating circuit (201, 301-303, 501) comprises an inductor (L) and a capacitor (C) connected in series, wherein a first terminal of the inductor (L) is connected to the measurement control circuit (502), a second terminal of the inductor (L) is connected to a first terminal of the capacitor (C), and a second terminal of the capacitor (C) is connected to a common voltage terminal or the measurement control circuit (502); or the second terminal of the capacitor (C) is connected to the measurement control circuit (502), the first terminal of the capacitor (C) is connected to the second terminal of the inductor (L), and the first terminal of the inductor (L) is connected to the common voltage terminal or the measurement control circuit (502);

the measurement control circuit (502) is configured to connect the inductor (L) and the capacitor (C) to the power supply (40, 504) in series to form a charging loop to charge the capacitor (C);
the measurement control circuit (502) is further configured to: connect the inductor (L) and the capacitor (C) to form an LC oscillating loop; or connect the inductor (L) and the capacitor (C) to form an LC oscillating loop, and connect a predetermined resistor (R) in series to the LC oscillating loop; and

the voltage sampling circuit (503) is connected to the first terminal of the capacitor (C), and is configured to sample a voltage of the capacitor (C) in the LC oscillating loop formed by the inductor (L) and the capacitor (C) to obtain a first peak voltage, or sample a voltage of the capacitor (C) in the LC oscillating loop formed by the inductor (L), the capacitor (C), and the predetermined resistor (R) to obtain a second peak voltage, wherein the first peak voltage and the second peak voltage are used to calculate a quality factor Q value of the inductor (L); **characterized in that** the measurement control circuit (502) comprises a first switching assembly (K1), a second switching assembly (K2), and the predetermined resistor (R);

a first terminal of the first switching assembly (K1) is connected to the power supply (40, 504), a second terminal of the first switching assembly (K1) is connected to the common voltage terminal or the second terminal of the capacitor (C), a third terminal of the first switching assembly (K1) is connected to a first terminal of the predetermined resistor (R), and a second terminal of the predetermined resistor (R) is connected to the first terminal of the inductor (L); and a first terminal of the second switching assembly (K2) is connected to the first terminal of the predetermined resistor (R), and a second terminal of the second switching assembly (K2) is connected to the second terminal of the predetermined resistor (R); or the first terminal of the first switching assembly (K1) is connected to the power supply (40, 504), the second terminal of the first switching assembly (K1) is connected to the common voltage terminal or the first terminal of the inductor (L), the third terminal of the first switching assembly (K1) is connected to the first terminal of the predetermined resistor (R), and the second terminal of the predetermined resistor (R) is connected to the second terminal of the capacitor (C); and the first terminal of the second switching assembly (K2) is connected to the first terminal of the predetermined resistor (R), and the second terminal of the second switching assembly (K2) is connected to the second terminal of the predetermined resistor (R), wherein

when the first terminal of the first switching assembly (K1) is connected to the third terminal of the first switching assembly (K1), and the first terminal of the second switching assembly (K2) is connected to the second terminal of the second switching assembly (K2), the inductor (L) and the capacitor (C) are connected to the power supply (40, 504) in series to form the charging loop to charge the capacitor (C);

when the second terminal of the first switching assembly (K1) is connected to the third terminal of the first switching assembly (K1), and the first terminal of the second switching assembly (K2) is connected to the second terminal of the second switching assembly (K2), the inductor (L) and the capacitor (C) are connected to form the LC oscillating loop; and

when the second terminal of the first switching assembly (K1) is connected to the third terminal of the first switching assembly (K1), and the first terminal of the second switching assembly (K2) is disconnected from the second terminal of the second switching assembly (K2), the inductor (L) and the capacitor (C) are connected to form the LC oscillating loop, and the predetermined resistor (R) is connected in series to the LC oscillating loop.

2. The quality factor measurement circuit based on an oscillating circuit (201, 301-303, 501) according to claim 1, wherein the first peak voltage is a maximum peak forward voltage of a damped oscillation voltage generated at the first terminal of the capacitor (C) by the LC oscillating loop formed by connecting the inductor (L) and the capacitor (C); and the second peak voltage is a maximum peak forward voltage of a damped oscillation voltage generated at the first terminal of the capacitor (C) by the LC oscillating loop formed by connecting the predetermined resistor (R), the inductor (L), and the capacitor (C).

3. The quality factor measurement circuit based on an oscillating circuit (201, 301-303, 501) according to claim 1 or 2, wherein the voltage sampling circuit (503) comprises any one of the following: a voltage follower circuit, a peak voltage sampling circuit, a cycle-by-cycle peak voltage sampling circuit, and a voltage attenuation detection circuit.

4. A quality factor measurement method based on an oscillating circuit (201, 301-303, 501), applied to a quality factor measurement circuit based on an oscillating circuit (201, 301-303, 501), which comprises: the oscillating circuit (201, 301-303, 501), a measurement control circuit (502), and a voltage sampling circuit (503), wherein the measurement control circuit (502) is connected to a power supply (40, 504), and the measurement control circuit (502) is connected to the oscillating circuit (201, 301-303, 501); and the oscillating circuit (201, 301-303, 501) comprises an inductor (L) and a capacitor (C) connected in series, wherein a first terminal of the inductor (L) is connected to the measurement control circuit (502), a second terminal of the inductor (L) is connected to a first terminal of the capacitor (C), and a second terminal of the capacitor (C) is connected to a common voltage terminal or the measurement control circuit (502); or the second terminal of the capacitor (C) is connected to the measurement control circuit (502), the first terminal of the capacitor (C) is connected to the second terminal of the inductor (L), and the first terminal of the inductor (L) is connected to the common voltage terminal or the measurement control circuit (502); and the quality factor measurement method based on an oscillating circuit (201, 301-303, 501) comprises:

controlling the measurement control circuit (502) to connect the inductor (L) and the capacitor (C) to the power supply (40, 504) in series to form a charging loop to charge the capacitor (C);

controlling the measurement control circuit (502) to connect the inductor (L) and the capacitor (C) to form an LC oscillating loop, in which the voltage sampling circuit (503) samples a voltage of the capacitor (C) to obtain a first peak voltage of the capacitor (C); or controlling the measurement control circuit (502) to connect the inductor (L) and the capacitor (C) to form an LC oscillating loop, and connect a predetermined resistor (R) in series to the LC oscillating loop, in which the voltage sampling circuit (503) samples a voltage of the capacitor (C) to obtain a second peak voltage of the capacitor (C); and

calculating a Q value of the inductor (L) based on the first peak voltage and the second peak voltage;

**characterized in that** the measurement control circuit (502) comprises a first switching assembly (K1), a second switching assembly (K2), and the predetermined resistor (R); a first terminal of the first switching assembly (K1) is connected to the power supply (40, 504), a second terminal of the first switching assembly (K1) is connected to the common voltage terminal or the second terminal of the capacitor (C), a third terminal of the first switching assembly (K1) is connected to a first terminal of the predetermined resistor (R), and a second terminal of the predetermined resistor (R) is connected to the first terminal of the inductor (L); and a first terminal of the second switching assembly (K2) is connected to the first terminal of the predetermined resistor (R), and a second terminal of the second switching assembly (K2) is connected to the second terminal of the predetermined resistor (R); or the first terminal of the first switching assembly (K1) is connected to the power supply (40, 504), the second terminal of the first switching assembly (K1) is connected to the common voltage terminal or the first terminal of the inductor (L), the third terminal of the first switching assembly (K1) is connected to the first terminal of the predetermined resistor (R), and the second terminal of the predetermined resistor (R) is connected to the second terminal of the capacitor (C); and the first terminal of the second switching assembly (K2) is connected to the first terminal of the predetermined resistor (R), and the second terminal of the second switching assembly (K2) is connected to the second terminal of the predetermined resistor (R), wherein

the controlling the measurement control circuit (502) to connect the inductor (L) and the capacitor (C) to the power supply (40, 504) in series to form a charging loop comprises: controlling the first terminal of the first switching assembly (K1) to be connected to the third terminal of the first switching assembly (K1), and the first terminal of the second switching assembly (K2) to be connected to the second terminal of the second switching assembly (K2);

the controlling the measurement control circuit (502) to connect the inductor (L) and the capacitor (C) to form an LC oscillating loop comprises: controlling the second terminal of the first switching assembly (K1) to be connected to the third terminal of the first switching assembly (K1), and the first terminal of the second switching assembly (K2) to be connected to the second terminal of the second switching assembly (K2); and

the controlling the measurement control circuit (502) to connect the inductor (L) and the capacitor (C) to form an LC oscillating loop, and connect a predetermined resistor (R) in series to the LC oscillating loop comprises: controlling the second terminal of the first switching assembly (K1) to be connected to the third terminal of the first switching assembly (K1), and the first terminal of the second switching assembly (K2) to be disconnected from the second terminal of the second switching assembly (K2).

5.  The quality factor measurement method based on an oscillating circuit (201, 301-303, 501) according to claim 4, wherein calculating a Q value of the inductor (L) based on a first sampling voltage and a second sampling voltage comprises:

calculating an equivalent inductance value of the inductor (L) by using the following formula 1, and calculating an equivalent impedance of the inductor (L) by using the following formula 2:

$$L1 = \frac{R^2 Cp}{4\left(\sqrt{\frac{\left(\ln U1/Us\right)^2}{(n*\pi)^2 + \left(\ln U1/Us\right)^2}} - \sqrt{\frac{\left(\ln U2/Us\right)^2}{(n*\pi)^2 + \left(\ln U2/Us\right)^2}}\right)^2} \qquad \text{formula 1;}$$

$$R1 = \frac{R}{\sqrt{\dfrac{\dfrac{(\ln U1/Us)^2}{(n^*\pi)^2 + (\ln U1/Us)^2}}{\dfrac{(\ln U2/Us)^2}{(n^*\pi)^2 + (\ln U2/Us)^2}}} - 1} \qquad \text{formula 2;}$$

and

calculating the Q value of the inductor (L) based on the equivalent inductance value and the equivalent impedance, wherein L1 is the equivalent inductance value of the inductor (L), R1 is the equivalent impedance of the inductor (L), Us is an output voltage of the power supply (40, 504), U1 is the first sampling voltage, U2 is the second sampling voltage, R is a resistance value of the predetermined resistor (R), n is a positive integer, and Cp is a capacitance value of the capacitor (C).

6. A quality factor measurement apparatus based on an oscillating circuit (201, 301-303, 501), configured to control a quality factor measurement circuit based on an oscillating circuit (201, 301-303, 501), which comprises: the oscillating circuit (201, 301-303, 501), a measurement control circuit (502), and a voltage sampling circuit (503), wherein the measurement control circuit (502) is connected to a power supply (40, 504), and the measurement control circuit (502) is connected to the oscillating circuit (201, 301-303, 501); and the oscillating circuit (201, 301-303, 501) comprises an inductor (L) and a capacitor (C) connected in series, wherein a first terminal of the inductor (L) is connected to the measurement control circuit (502), a second terminal of the inductor (L) is connected to a first terminal of the capacitor (C), and a second terminal of the capacitor (C) is connected to a common voltage terminal or the measurement control circuit (502); or the second terminal of the capacitor (C) is connected to the measurement control circuit (502), the first terminal of the capacitor (C) is connected to the second terminal of the inductor (L), and the first terminal of the inductor (L) is connected to the common voltage terminal or the measurement control circuit (502); and the quality factor measurement apparatus based on an oscillating circuit (201, 301-303, 501) comprises:

a control module (2001), configured to control the measurement control circuit (502) to connect the inductor (L) and the capacitor (C) to the power supply (40, 504) in series to form a charging loop to charge the capacitor (C), wherein

the control module (2001) is further configured to: control the measurement control circuit (502) to connect the inductor (L) and the capacitor (C) to form an LC oscillating loop, in which the voltage sampling circuit (503) samples a voltage of the capacitor (C) to obtain a first peak voltage of the capacitor (C); or control the measurement control circuit (502) to connect the inductor (L) and the capacitor (C) to form an LC oscillating loop, and connect a predetermined resistor (R) in series to the LC oscillating loop, in which the voltage sampling circuit (503) samples a voltage of the capacitor (C) to obtain a second peak voltage of the capacitor (C); and a processing module (2002), configured to calculate a Q value of the inductor (L) based on the first peak voltage and the second peak voltage obtained by the voltage sampling circuit (503);

**characterized in that** the measurement control circuit (502) comprises a first switching assembly (K1), a second switching assembly (K2), and the predetermined resistor (R); a first terminal of the first switching assembly (K1) is connected to the power supply (40, 504), a second terminal of the first switching assembly (K1) is connected to the common voltage terminal or the second terminal of the capacitor (C), a third terminal of the first switching assembly (K1) is connected to a first terminal of the predetermined resistor (R), and a second terminal of the predetermined resistor (R) is connected to the first terminal of the inductor (L); and a first terminal of the second switching assembly (K2) is connected to the first terminal of the predetermined resistor (R), and a second terminal of the second switching assembly (K2) is connected to the second terminal of the predetermined resistor (R); or the first terminal of the first switching assembly (K1) is connected to the power supply (40, 504), the second terminal of the first switching assembly (K1) is connected to the common voltage terminal or the first terminal of the inductor (L), the third terminal of the first switching assembly (K1) is connected to the first terminal of the predetermined resistor (R), and the second terminal of the predetermined resistor (R) is connected to the second terminal of the capacitor (C); and the first terminal of the second switching assembly (K2) is connected to the first terminal of the predetermined resistor (R), and the second terminal of the second switching assembly (K2) is connected to the second terminal of the predetermined resistor (R), wherein

the control module (2001) is specifically configured to control the first terminal of the first switching assembly (K1) to be connected to the third terminal of the first switching assembly (K1), and the first terminal of the second switching assembly (K2) to be connected to the second terminal of the second switching assembly (K2); the control module (2001) is specifically configured to control the second terminal of the first switching assembly (K1) to be connected to the third terminal of the first switching assembly (K1), and the first terminal of the second switching assembly (K2) to be connected to the second terminal of the second switching assembly (K2); and the control module (2001) is specifically configured to control the second terminal of the first switching assembly (K1) to be connected to the third terminal of the first switching assembly (K1), and the first terminal of the second switching assembly (K2) to be disconnected from the second terminal of the second switching assembly (K2).

7. An electronic device, comprising: the quality factor measurement circuit based on an oscillating circuit (201, 301-303, 501) according to any one of claims 1 to 3, and the quality factor measurement apparatus based on an oscillating circuit (201, 301-303, 501) according to claim 6, wherein the electronic device may be a transmitter device or a receiver device.

**Patentansprüche**

1. Auf einem Schwingkreis (201, 301-303, 501) basierende Qualitätsfaktor-Messschaltung, die Folgendes umfasst: den Schwingkreis (201, 301-303, 501), eine Messsteuerschaltung (502) und eine Spannungsabtastschaltung (503), wobei die Messsteuerschaltung (502) mit einer Leistungsversorgung (40, 504) verbunden ist und die Messsteuerschaltung (502) mit dem Schwingkreis (201, 301-303, 501) verbunden ist; und der Schwingkreis (201, 301-303, 501) eine Induktivität (L) und einen Kondensator (C) umfasst, die in Reihe geschaltet sind, wobei ein erster Anschluss der Induktivität (L) mit der Messsteuerschaltung (502) verbunden ist, ein zweiter Anschluss der Induktivität (L) mit einem ersten Anschluss des Kondensators (C) verbunden ist und ein zweiter Anschluss des Kondensators (C) mit einem gemeinsamen Spannungsanschluss oder der Messsteuerschaltung (502) verbunden ist; oder der zweite Anschluss des Kondensators (C) mit der Messsteuerschaltung (502) verbunden ist, der erste Anschluss des Kondensators (C) mit dem zweiten Anschluss der Induktivität (L) verbunden ist und der erste Anschluss der Induktivität (L) mit dem gemeinsamen Spannungsanschluss oder der Messsteuerschaltung (502) verbunden ist;

die Messsteuerschaltung (502) konfiguriert ist, um die Induktivität (L) und den Kondensator (C) in Reihe mit der Leistungsversorgung (40, 504) zu schalten, um eine Ladeschleife zu bilden, um den Kondensator (C) zu laden; die Messsteuerschaltung (502) ferner zu Folgendem konfiguriert ist: Verbinden der Induktivität (L) und des Kondensators (C), um eine LC-Schwingschleife zu bilden; oder Verbinden der Induktivität (L) und des Kondensators (C), um eine LC-Schwingschleife zu bilden, und Schalten eines vorbestimmten Widerstands (R) in Reihe mit der LC-Schwingschleife; und die Spannungsabtastschaltung (503) mit dem ersten Anschluss des Kondensators (C) verbunden ist und konfiguriert ist, um eine Spannung des Kondensators (C) in der durch die Induktivität (L) und den Kondensator (C) gebildeten LC-Schwingschleife abzutasten, um eine erste Spitzenspannung zu erhalten, oder eine Spannung des Kondensators (C) in der durch die Induktivität (L), den Kondensator (C) und den vorbestimmten Widerstand (R) gebildeten LC-Schwingschleife abzutasten, um eine zweite Spitzenspannung zu erhalten, wobei die erste Spitzenspannung und die zweite Spitzenspannung verwendet werden, um einen Qualitätsfaktor-Q-Wert der Induktivität (L) zu berechnen; **dadurch gekennzeichnet, dass** die Messsteuerschaltung (502) eine erste Schaltanordnung (K1), eine zweite Schaltanordnung (K2) und den vorbestimmten Widerstand (R) umfasst; ein erster Anschluss der ersten Schaltanordnung (K1) mit der Leistungsversorgung (40, 504) verbunden ist, ein zweiter Anschluss der ersten Schaltanordnung (K1) mit dem gemeinsamen Spannungsanschluss oder dem zweiten Anschluss des Kondensators (C) verbunden ist, ein dritter Anschluss der ersten Schaltanordnung (K1) mit einem ersten Anschluss des vorbestimmten Widerstands (R) verbunden ist und ein zweiter Anschluss des vorbestimmten Widerstands (R) mit dem ersten Anschluss der Induktivität (L) verbunden ist; und ein erster Anschluss der zweiten Schaltanordnung (K2) mit dem ersten Anschluss des vorbestimmten Widerstands (R) verbunden ist und ein zweiter Anschluss der zweiten Schaltanordnung (K2) mit dem zweiten Anschluss des vorbestimmten Widerstands (R) verbunden ist; oder der erste Anschluss der ersten Schaltanordnung (K1) mit der Leistungsversorgung (40, 504) verbunden ist, der zweite Anschluss der ersten Schaltanordnung (K1) mit dem gemeinsamen Spannungsanschluss oder dem ersten Anschluss der Induktivität (L) verbunden ist, der dritte Anschluss der ersten Schaltanordnung (K1) mit dem ersten Anschluss des vorbestimmten Widerstands (R) verbunden ist und der zweite Anschluss des vorbestimmten Widerstands (R) mit dem zweiten Anschluss des Kondensators (C) verbunden ist; und der erste Anschluss der zweiten Schaltanordnung (K2) mit dem ersten Anschluss des vorbestimmten Widerstands (R) verbunden ist und der zweite Anschluss der zweiten Schaltanordnung (K2) mit dem zweiten Anschluss des vorbestimmten Widerstands (R) verbunden ist, wobei,

wenn der erste Anschluss der ersten Schaltanordnung (K1) mit dem dritten Anschluss der ersten Schaltanordnung (K1) verbunden ist und der erste Anschluss der zweiten Schaltanordnung (K2) mit dem zweiten Anschluss der zweiten Schaltanordnung (K2) verbunden ist, die Induktivität (L) und der Kondensator (C) in Reihe mit der Leistungsversorgung (40, 504) geschaltet sind, um die Ladeschleife zu bilden, um den Kondensator (C) zu laden;

wenn der zweite Anschluss der ersten Schaltanordnung (K1) mit dem dritten Anschluss der ersten Schaltanordnung (K1) verbunden ist und der erste Anschluss der zweiten Schaltanordnung (K2) mit dem zweiten Anschluss der zweiten Schaltanordnung (K2) verbunden ist, die Induktivität (L) und der Kondensator (C) miteinander verbunden sind, um die LC-Schwingschleife zu bilden; und

wenn der zweite Anschluss der ersten Schaltanordnung (K1) mit dem dritten Anschluss der ersten Schaltanordnung (K1) verbunden ist und der erste Anschluss der zweiten Schaltanordnung (K2) von dem zweiten Anschluss der zweiten Schaltanordnung (K2) getrennt ist, die Induktivität (L) und der Kondensator (C) verbunden sind, um die LC-Schwingschleife zu bilden, und der vorbestimmte Widerstand (R) in Reihe mit der LC-Schwingschleife geschaltet ist.

2. Auf einem Schwingkreis (201, 301-303, 501) basierende Qualitätsfaktor-Messschaltung nach Anspruch 1, wobei die erste Spitzenspannung eine maximale Spitzendurchlassspannung einer gedämpften Schwingspannung ist, die an dem ersten Anschluss des Kondensators (C) von der durch Verbinden der Induktivität (L) und des Kondensators (C) gebildeten LC-Schwingschleife erzeugt wird; und die zweite Spitzenspannung eine maximale Spitzendurchlassspannung einer gedämpften Schwingspannung ist, die an dem ersten Anschluss des Kondensators (C) von der durch Verbinden des vorbestimmten Widerstands (R), der Induktivität (L) und des Kondensators (C) gebildeten LC-Schwingschleife erzeugt wird.

3. Auf einem Schwingkreis (201, 301-303, 501) basierende Qualitätsfaktor-Messschaltung nach Anspruch 1 oder 2, wobei die Spannungsabtastschaltung (503) eines der Folgenden umfasst: eine Spannungsfolgerschaltung, eine Spitzenspannungsabtastschaltung, eine zyklusweise Spitzenspannungsabtastschaltung und eine Spannungsdämpfungserkennungsschaltung.

4. Auf einem Schwingkreis (201, 301-303, 501) basierendes Qualitätsfaktor-Messverfahren, das auf eine auf einem Schwingkreis (201, 301-303, 501) basierende Qualitätsfaktor-Messschaltung angewendet wird, die Folgendes umfasst: den Schwingkreis (201, 301-303, 501), eine Messsteuerschaltung (502) und eine Spannungsabtastschaltung (503), wobei die Messsteuerschaltung (502) mit einer Leistungsversorgung (40, 504) verbunden ist und die Messsteuerschaltung (502) mit dem Schwingkreis (201, 301-303, 501) verbunden ist; und der Schwingkreis (201, 301-303, 501) eine Induktivität (L) und einen Kondensator (C) umfasst, die in Reihe geschaltet sind, wobei ein erster Anschluss der Induktivität (L) mit der Messsteuerschaltung (502) verbunden ist, ein zweiter Anschluss der Induktivität (L) mit einem ersten Anschluss des Kondensators (C) verbunden ist und ein zweiter Anschluss des Kondensators (C) mit einem gemeinsamen Spannungsanschluss oder der Messsteuerschaltung (502) verbunden ist; oder der zweite Anschluss des Kondensators (C) mit der Messsteuerschaltung (502) verbunden ist, der erste Anschluss des Kondensators (C) mit dem zweiten Anschluss der Induktivität (L) verbunden ist und der erste Anschluss der Induktivität (L) mit dem gemeinsamen Spannungsanschluss oder der Messsteuerschaltung (502) verbunden ist; und das auf einem Schwingkreis (201, 301-303, 501) basierende Qualitätsfaktor-Messverfahren Folgendes umfasst:

Steuern der Messsteuerschaltung (502) so, dass die Induktivität (L) und der Kondensator (C) in Reihe mit der Leistungsversorgung (40, 504) geschaltet werden, um eine Ladeschleife zu bilden, um den Kondensator (C) zu laden;

Steuern der Messsteuerschaltung (502) so, dass die Induktivität (L) und der Kondensator (C) verbunden werden, um eine LC-Schwingschleife zu bilden, in der die Spannungsabtastschaltung (503) eine Spannung des Kondensators (C) abtastet, um eine erste Spitzenspannung des Kondensators (C) zu erhalten; oder Steuern der Messsteuerschaltung (502) so, dass die Induktivität (L) und der Kondensator (C) verbunden werden, um eine LC-Schwingschleife zu bilden, und ein vorbestimmter Widerstand (R) in Reihe mit der LC-Schwingschleife, in der die Spannungsabtastschaltung (503) eine Spannung des Kondensators (C) abtastet, um eine zweite Spitzenspannung des Kondensators (C) zu erhalten, geschaltet wird; und

Berechnen eines Q-Werts der Induktivität (L) basierend auf der ersten Spitzenspannung und der zweiten Spitzenspannung;

**dadurch gekennzeichnet, dass** die Messsteuerschaltung (502) eine erste Schaltanordnung (K1), eine zweite Schaltanordnung (K2) und den vorbestimmten Widerstand (R) umfasst; ein erster Anschluss der ersten Schaltanordnung (K1) mit der Leistungsversorgung (40, 504) verbunden ist, ein zweiter Anschluss der ersten Schaltanordnung (K1) mit dem gemeinsamen Spannungsanschluss oder dem zweiten Anschluss des Kondensators (C) verbunden ist, ein dritter Anschluss der ersten Schaltanordnung (K1) mit einem ersten Anschluss des vorbestimmten Widerstands (R) verbunden ist und ein zweiter Anschluss des vorbestimmten Widerstands (R) mit dem ersten Anschluss der Induktivität (L) verbunden ist; und ein erster Anschluss der zweiten Schaltanordnung (K2) mit dem ersten Anschluss des vorbestimmten Widerstands (R) verbunden ist und ein zweiter Anschluss der zweiten Schaltanordnung (K2) mit dem zweiten Anschluss des vorbestimmten Widerstands (R) verbunden ist; oder der erste Anschluss der ersten Schaltanordnung (K1) mit der Leistungsversorgung (40, 504) verbunden ist, der zweite Anschluss der ersten Schaltanordnung (K1) mit dem gemeinsamen Spannungsanschluss oder dem ersten Anschluss der Induktivität (L) verbunden ist, der dritte Anschluss der ersten Schaltanordnung (K1) mit dem ersten Anschluss des vorbestimmten Widerstands (R) verbunden ist und der zweite Anschluss des vorbestimmten Widerstands (R) mit dem zweiten Anschluss des Kondensators (C) verbunden ist; und der erste Anschluss der zweiten Schaltanordnung (K2) mit dem ersten Anschluss des vorbestimmten Widerstands (R) verbunden ist und der zweite Anschluss der zweiten Schaltanordnung (K2) mit dem zweiten Anschluss des vorbestimmten Widerstands (R) verbunden ist, wobei

das Steuern der Messsteuerschaltung (502) so, dass die Induktivität (L) und der Kondensator (C) in Reihe mit der Leistungsversorgung (40, 504) geschaltet werden, um eine Ladeschleife zu bilden, Folgendes umfasst: Steuern des ersten Anschlusses der ersten Schaltanordnung (K1) so, dass er mit dem dritten Anschluss der ersten Schaltanordnung (K1) verbunden wird, und des ersten Anschlusses der zweiten Schaltanordnung (K2) so, dass er mit dem zweiten Anschluss der zweiten Schaltanordnung (K2) verbunden wird;

das Steuern der Messsteuerschaltung (502) so, dass die Induktivität (L) und der Kondensator (C) verbunden werden, um eine LC-Schwingschleife zu bilden, Folgendes umfasst: Steuern des zweiten Anschlusses der ersten Schaltanordnung (K1) so, dass er mit dem dritten Anschluss der ersten Schaltanordnung (K1) verbunden wird, und des ersten Anschlusses der zweiten Schaltanordnung (K2) so, dass er mit dem zweiten Anschluss der zweiten Schaltanordnung (K2) verbunden wird; und

das Steuern der Messsteuerschaltung (502) so, dass die Induktivität (L) und der Kondensator (C) verbunden werden, um eine LC-Schwingschleife zu bilden, und ein vorbestimmter Widerstand (R) in Reihe mit der LC-Schwingschleife geschaltet wird,

Folgendes umfasst: Steuern des zweiten Anschlusses der ersten Schaltanordnung (K1) so, dass er mit dem dritten Anschluss der ersten Schaltanordnung (K1) verbunden wird, und des ersten Anschlusses der zweiten Schaltanordnung (K2) so, dass er von dem zweiten Anschluss der zweiten Schaltanordnung (K2) getrennt wird.

5. Auf einem Schwingkreis (201, 301-303, 501) basierendes Qualitätsfaktor-Messverfahren nach Anspruch 4, wobei das Berechnen eines Q-Werts der Induktivität (L) basierend auf einer ersten Abtastspannung und einer zweiten Abtastspannung Folgendes umfasst:

Berechnen eines äquivalenten Induktivitätswerts der Induktivität (L) durch Verwenden der folgenden Formel 1 und Berechnen einer äquivalenten Impedanz der Induktivität (L) durch Verwenden der folgenden Formel 2:

$$L1 = \frac{R^2 Cp}{4\left(\sqrt{\dfrac{(\ln U1/Us)^2}{(n*\pi)^2 + (\ln U1/Us)^2}} - \sqrt{\dfrac{(\ln U2/Us)^2}{(n*\pi)^2 + (\ln U2/Us)^2}}\right)^2}$$ Formel 1;

$$R1 = \frac{R}{\dfrac{\sqrt{\dfrac{(\ln U1/Us)^2}{(n*\pi)^2 + (\ln U1/Us)^2}}}{\sqrt{\dfrac{(\ln U2/Us)^2}{(n*\pi)^2 + (\ln U2/Us)^2}}} - 1}$$ Formel 2;

und

Berechnen des Q-Werts der Induktivität (L) basierend auf dem äquivalenten Induktivitätswert und der äquivalenten Impedanz, wobei L1 der äquivalente Induktivitätswert der Induktivität (L) ist, R1 die äquivalente Impedanz der Induktivität (L) ist, Us eine Ausgangsspannung der Leistungsversorgung (40, 504) ist, U1 die erste Abtastspannung ist, U2 die zweite Abtastspannung ist, R ein Widerstandswert des vorbestimmten Widerstands (R) ist, n eine positive Ganzzahl ist und Cp ein Kapazitätswert des Kondensators (C) ist.

6. Auf einem Schwingkreis (201, 301-303, 501) basierende Qualitätsfaktor-Messeinrichtung, die konfiguriert ist, um eine Qualitätsfaktor-Messschaltung zu steuern, die auf einem Schwingkreis (201, 301-303, 501) basiert, die Folgendes umfasst: den Schwingkreis (201, 301-303, 501), eine Messsteuerschaltung (502) und eine Spannungsabtastschaltung (503), wobei die Messsteuerschaltung (502) mit einer Leistungsversorgung (40, 504) verbunden ist und die Messsteuerschaltung (502) mit dem Schwingkreis (201, 301-303, 501) verbunden ist; und der Schwingkreis (201, 301-303, 501) eine Induktivität (L) und einen Kondensator (C) umfasst, die in Reihe geschaltet sind, wobei ein erster Anschluss der Induktivität (L) mit der Messsteuerschaltung (502) verbunden ist, ein zweiter Anschluss der Induktivität (L) mit einem ersten Anschluss des Kondensators (C) verbunden ist und ein zweiter Anschluss des Kondensators (C) mit einem gemeinsamen Spannungsanschluss oder der Messsteuerschaltung (502) verbunden ist; oder der zweite Anschluss des Kondensators (C) mit der Messsteuerschaltung (502) verbunden ist, der erste Anschluss des Kondensators (C) mit dem zweiten Anschluss der Induktivität (L) verbunden ist und der erste Anschluss der Induktivität (L) mit dem gemeinsamen Spannungsanschluss oder der Messsteuerschaltung (502) verbunden ist; und die auf einem Schwingkreis (201, 301-303, 501) basierende Qualitätsfaktor-Messeinrichtung Folgendes umfasst:

ein Steuermodul (2001), das konfiguriert ist, um die Messsteuerschaltung (502) so zu steuern, dass die Induktivität (L) und der Kondensator (C) in Reihe mit der Leistungsversorgung (40, 504) geschaltet werden, um eine Ladeschleife zu bilden, um den Kondensator (C) zu laden, wobei das Steuermodul (2001) ferner konfiguriert ist zum: Steuern der Messsteuerschaltung (502) so, dass die Induktivität (L) und der Kondensator (C) verbunden werden, um eine LC-Schwingschleife zu bilden, in der die Spannungsabtastschaltung (503) eine Spannung des Kondensators (C) abtastet, um eine erste Spitzenspannung des Kondensators (C) zu erhalten; oder Steuern der Messsteuerschaltung (502) so, dass die Induktivität (L) und der Kondensator (C) verbunden werden, um eine LC-Schwingschleife zu bilden, und ein vorbestimmter Widerstand (R) in Reihe mit der LC-Schwingschleife, in der die Spannungsabtastschaltung (503) eine Spannung des Kondensators (C) abtastet, um eine zweite Spitzenspannung des Kondensators (C) zu erhalten, geschaltet wird; und ein Verarbeitungsmodul (2002), das konfiguriert ist, um einen Q-Wert der Induktivität (L) basierend auf der ersten Spitzenspannung und der zweiten Spitzenspannung zu berechnen, die durch die Spannungsabtastschaltung (503) erhalten werden;

**dadurch gekennzeichnet, dass** die Messsteuerschaltung (502) eine erste Schaltanordnung (K1), eine zweite Schaltanordnung (K2) und den vorbestimmten Widerstand (R) umfasst; ein erster Anschluss der ersten Schaltanordnung (K1) mit der Leistungsversorgung (40, 504) verbunden ist, ein zweiter Anschluss der ersten Schaltanordnung (K1) mit dem gemeinsamen Spannungsanschluss oder dem zweiten Anschluss des Kondensators (C) verbunden ist, ein dritter Anschluss der ersten Schaltanordnung (K1) mit einem ersten Anschluss des vorbestimmten Widerstands (R) verbunden ist und ein zweiter Anschluss des vorbestimmten Widerstands (R) mit dem ersten Anschluss der Induktivität (L) verbunden ist; und ein erster Anschluss der zweiten Schaltanordnung (K2) mit dem ersten Anschluss des vorbestimmten Widerstands (R) verbunden ist und ein zweiter Anschluss der zweiten Schaltanordnung (K2) mit dem zweiten Anschluss des vorbestimmten Widerstands (R) verbunden ist; oder der erste Anschluss der ersten Schaltanordnung (K1) mit der Leistungsversorgung (40, 504) verbunden ist, der zweite Anschluss der ersten Schaltanordnung (K1) mit dem gemeinsamen Spannungsanschluss oder dem ersten Anschluss der Induktivität (L) verbunden ist, der dritte Anschluss der ersten Schaltanordnung (K1) mit dem ersten Anschluss des vorbestimmten Widerstands (R) verbunden ist und der zweite Anschluss des vorbestimmten Widerstands (R) mit dem zweiten Anschluss des Kondensators (C) verbunden ist; und der erste Anschluss der zweiten Schaltanordnung (K2) mit dem ersten Anschluss des vorbestimmten Widerstands (R) verbunden ist und der zweite Anschluss der zweiten Schaltanordnung (K2) mit dem zweiten Anschluss des vorbestimmten Widerstands (R) verbunden ist, wobei das Steuermodul (2001) insbesondere konfiguriert ist, um Folgendes zu steuern: den ersten Anschluss der ersten Schaltanordnung (K1) so, dass er mit dem dritten Anschluss der ersten Schaltanordnung (K1) verbunden wird, und den ersten Anschluss der zweiten Schaltanordnung (K2) so, dass er mit dem zweiten Anschluss der zweiten Schaltanordnung (K2) verbunden wird; das Steuermodul (2001) insbesondere konfiguriert ist, um Folgendes zu steuern: den zweiten Anschluss der ersten Schaltanordnung (K1) so, dass er mit dem dritten Anschluss der ersten Schaltanordnung (K1) verbunden wird, und den ersten Anschluss der zweiten Schaltanordnung (K2) so, dass er mit dem zweiten Anschluss der zweiten Schaltanordnung (K2) verbunden wird; und

das Steuermodul (2001) insbesondere konfiguriert ist, um Folgendes zu steuern: den zweiten Anschluss der ersten Schaltanordnung (K1) so, dass er mit dem dritten Anschluss der ersten Schaltanordnung (K1) verbunden wird, und den ersten Anschluss der zweiten Schaltanordnung (K2) so, dass er von dem zweiten Anschluss der zweiten Schaltanordnung (K2) getrennt wird.

7. Elektronische Vorrichtung, die Folgendes umfasst: die auf einem Schwingkreis (201, 301-303, 501) basierende Qualitätsfaktor-Messschaltung nach einem der Ansprüche 1 bis 3 und die auf einem Schwingkreis (201, 301-303, 501) basierende Qualitätsfaktor-Messeinrichtung nach Anspruch 6, wobei die elektronische Vorrichtung eine Sendervorrichtung oder eine Empfängervorrichtung sein kann.

**Revendications**

1. Circuit de mesure de facteur de qualité basé sur un circuit oscillant (201, 301-303, 501), comprenant : le circuit oscillant (201, 301-303, 501), un circuit de commande de mesure (502), et un circuit d'échantillonnage de tension (503), dans lequel le circuit de commande de mesure (502) est connecté à une alimentation électrique (40, 504), et le circuit de commande de mesure (502) est connecté au circuit oscillant (201, 301-303, 501) ; et le circuit oscillant (201, 301-303, 501) comprend un inducteur (L) et un condensateur (C) connectés en série, dans lequel une première borne de la bobine d'induction (L) est connectée au circuit de commande de mesure (502), une deuxième borne de la bobine d'induction (L) est connectée à une première borne du condensateur (C), et une deuxième borne du condensateur (C) est connectée à une borne de tension commune ou au circuit de commande de mesure (502) ; ou la deuxième borne du condensateur (C) est connectée au circuit de commande de mesure (502), la première borne du condensateur (C) est connectée à la deuxième borne de la bobine d'induction (L), et la première borne de la bobine d'induction (L) est connectée à la borne de tension commune ou au circuit de commande de mesure (502) ;

le circuit de commande de mesure (502) est configuré pour connecter la bobine d'induction (L) et le condensateur (C) à l'alimentation électrique (40, 504) en série pour former une boucle de charge afin de charger le condensateur (C) ;
le circuit de commande de mesure (502) est en outre configuré pour : connecter la bobine d'induction (L) et le condensateur (C) pour former une boucle oscillante LC ; ou connecter la bobine d'induction (L) et le condensateur (C) pour former une boucle oscillante LC, et connecter une résistance prédéterminée (R) en série à la boucle oscillante LC ; et
le circuit d'échantillonnage de tension (503) est connecté à la première borne du condensateur (C) et est configuré pour échantillonner une tension du condensateur (C) dans la boucle oscillante LC formée par la bobine d'induction (L) et le condensateur (C) pour obtenir une première tension de crête, ou échantillonner une tension du condensateur (C) dans la boucle oscillante LC formée par la bobine d'induction (L), le condensateur (C) et la résistance prédéterminée (R) pour obtenir une seconde tension de crête, dans lequel la première tension de crête et la seconde tension de crête sont utilisées pour calculer une valeur de facteur de qualité Q de la bobine d'induction (L) ; **caractérisé en ce que** le circuit de commande de mesure (502) comprend un premier ensemble de commutation (K1), un second ensemble de commutation (K2) et la résistance prédéterminée (R) ;
une première borne du premier ensemble de commutation (K1) est connectée à l'alimentation électrique (40, 504), une deuxième borne du premier ensemble de commutation (K1) est connectée à la borne de tension commune ou à la deuxième borne du condensateur (C), une troisième borne du premier ensemble de commutation (K1) est connectée à une première borne de la résistance prédéterminée (R), et une deuxième borne de la résistance prédéterminée (R) est connectée à la première borne de la bobine d'induction (L) ; et une première borne du second ensemble de commutation (K2) est connectée à la première borne de la résistance prédéterminée (R), et une deuxième borne du second ensemble de commutation (K2) est connectée à la deuxième borne de la résistance prédéterminée (R) ; soit la première borne du premier ensemble de commutation (K1) est connectée à l'alimentation électrique (40, 504), la deuxième borne du premier ensemble de commutation (K1) est connectée à la borne de tension commune ou à la première borne de la bobine d'induction (L), la troisième borne du premier ensemble de commutation (K1) est connectée à la première borne de la résistance prédéterminée (R), et la deuxième borne de la résistance prédéterminée (R) est connectée à la deuxième borne du condensateur (C) ; et la première borne du second ensemble de commutation (K2) est connectée à la première borne de la résistance prédéterminée (R), et la deuxième borne du second ensemble de commutation (K2) est connectée à la deuxième borne de la résistance prédéterminée (R), dans lequel lorsque la première borne du premier ensemble de commutation (K1) est connectée à la troisième borne du premier ensemble de commutation (K1) et que la première borne du second ensemble de commutation (K2) est connectée à la deuxième borne du second ensemble de commutation (K2), la bobine d'induction (L) et le condensateur (C) sont connectés en série à l'alimentation électrique (40, 504) pour former la boucle de charge afin de charger le condensateur (C) ;

lorsque la deuxième borne du premier ensemble de commutation (K1) est connectée à la troisième borne du premier ensemble de commutation (K1) et que la première borne du second ensemble de commutation (K2) est connectée à la deuxième borne du second ensemble de commutation (K2), la bobine d'induction (L) et le condensateur (C) sont connectés pour former la boucle oscillante LC ; et

lorsque la deuxième borne du premier ensemble de commutation (K1) est connectée à la troisième borne du premier ensemble de commutation (K1) et que la première borne du second ensemble de commutation (K2) est déconnectée de la deuxième borne du second ensemble de commutation (K2), la bobine d'induction (L) et le condensateur (C) sont connectés pour former la boucle oscillante LC, et la résistance prédéterminée (R) est connectée en série à la boucle oscillante LC.

2. Circuit de mesure de facteur de qualité basé sur un circuit oscillant (201, 301-303, 501) selon la revendication 1, dans lequel la première tension de crête est une tension directe de crête maximale d'une tension oscillante amortie générée à la première borne du condensateur (C) par la boucle oscillante LC formée par la connexion de la bobine d'induction (L) et du condensateur (C) ; et la seconde tension de crête est une tension directe de crête maximale d'une tension oscillante amortie générée au niveau de la première borne du condensateur (C) par la boucle oscillante LC formée par la connexion de la résistance prédéterminée (R), de la bobine d'induction (L) et du condensateur (C).

3. Circuit de mesure de facteur de qualité basé sur un circuit oscillant (201, 301-303, 501) selon la revendication 1 ou 2, dans lequel le circuit d'échantillonnage de tension (503) comprend l'un quelconque de ce qui suit : un circuit suiveur de tension, un circuit d'échantillonnage de tension de crête, un circuit d'échantillonnage de tension de crête cycle par cycle et un circuit de détection d'atténuation de tension.

4. Procédé de mesure de facteur de qualité basé sur un circuit oscillant (201, 301-303, 501), appliqué à un circuit de mesure de facteur de qualité basé sur un circuit oscillant (201, 301-303, 501), qui comprend : le circuit oscillant (201, 301-303, 501), un circuit de commande de mesure (502), et un circuit d'échantillonnage de tension (503), dans lequel le circuit de commande de mesure (502) est connecté à une alimentation électrique (40, 504), et le circuit de commande de mesure (502) est connecté au circuit oscillant (201, 301-303, 501) ; et le circuit oscillant (201, 301-303, 501) comprend un inducteur (L) et un condensateur (C) connectés en série, dans lequel une première borne de la bobine d'induction (L) est connectée au circuit de commande de mesure (502), une deuxième borne de la bobine d'induction (L) est connectée à une première borne du condensateur (C), et une deuxième borne du condensateur (C) est connectée à une borne de tension commune ou au circuit de commande de mesure (502) ; ou la deuxième borne du condensateur (C) est connectée au circuit de commande de mesure (502), la première borne du condensateur (C) est connectée à la deuxième borne de la bobine d'induction (L), et la première borne de la bobine d'induction (L) est connectée à la borne de tension commune ou au circuit de commande de mesure (502) ; et le procédé de mesure de facteur de qualité basé sur un circuit oscillant (201, 301-303, 501) comprend :

la commande du circuit de commande de mesure (502) pour connecter la bobine d'induction (L) et le condensateur (C) à l'alimentation électrique (40, 504) en série pour former une boucle de charge pour charger le condensateur (C) ;

la commande du circuit de commande de mesure (502) pour connecter la bobine d'induction (L) et le condensateur (C) pour former une boucle oscillante LC, dans lequel le circuit d'échantillonnage de tension (503) échantillonne une tension du condensateur (C) pour obtenir une première tension de crête du condensateur (C) ; ou

la commande du circuit de commande de mesure (502) pour connecter la bobine d'induction (L) et le condensateur (C) pour former une boucle oscillante LC, et

connecter une résistance prédéterminée (R) en série à la boucle oscillante LC, dans lequel le circuit d'échantillonnage de tension (503) échantillonne une tension du condensateur (C) pour obtenir une seconde tension de crête du condensateur (C) ; et

le calcul d'une valeur Q de la bobine d'induction (L) sur la base de la première tension de crête et de la seconde tension de crête ;

**caractérisé en ce que** le circuit de commande de mesure (502) comprend un premier ensemble de commutation (K1), un second ensemble de commutation (K2) et la résistance prédéterminée (R) ; une première borne du premier ensemble de commutation (K1) est connectée à l'alimentation électrique (40, 504), une deuxième borne du premier ensemble de commutation (K1) est connectée à la borne de tension commune ou à la deuxième borne du condensateur (C), une troisième borne du premier ensemble de commutation (K1) est connectée à une première borne de la résistance prédéterminée (R), et une deuxième borne de la résistance prédéterminée (R) est connectée à la première borne de la bobine d'induction (L) ; et

une première borne du second ensemble de commutation (K2) est connectée à la première borne de la résistance prédéterminée (R), et une deuxième borne du second ensemble de commutation (K2) est connectée à la deuxième borne de la résistance prédéterminée (R) ; ou la première borne du premier ensemble de commutation (K1) est connectée à l'alimentation électrique (40, 504), la deuxième borne du premier ensemble de commutation (K1) est connectée à la borne de tension commune ou à la première borne de la bobine d'induction (L), la troisième borne du premier ensemble de commutation (K1) est connectée à la première borne de la résistance prédéterminée (R), et la deuxième borne de la résistance prédéterminée (R) est connectée à la deuxième borne du condensateur (C) ; et la première borne du second ensemble de commutation (K2) est connectée à la première borne de la résistance prédéterminée (R), et la deuxième borne du second ensemble de commutation (K2) est connectée à la deuxième borne de la résistance prédéterminée (R), dans lequel la commande du circuit de commande de mesure (502) pour connecter la bobine d'induction (L) et le condensateur (C) à l'alimentation électrique (40, 504) en série pour former une boucle de charge comprend : la commande de la première borne du premier ensemble de commutation (K1) à connecter à la troisième borne du premier ensemble de commutation (K1), et la première borne du second ensemble de commutation (K2) à connecter à la deuxième borne du second ensemble de commutation (K2) ;

la commande du circuit de commande de mesure (502) pour connecter la bobine d'induction (L) et le condensateur (C) pour former une boucle oscillante LC comprend : la commande de la deuxième borne du premier ensemble de commutation (K1) à connecter à la troisième borne du premier ensemble de commutation (K1), et la première borne du second ensemble de commutation (K2) à connecter à la deuxième borne du second ensemble de commutation (K2) ; et

la commande du circuit de commande de mesure (502) pour connecter la bobine d'induction (L) et le condensateur (C) pour former une boucle oscillante LC, et connecter une résistance prédéterminée (R) en série à la boucle oscillante LC comprend : la commande de la deuxième borne du premier ensemble de commutation (K1) à connecter à la troisième borne du premier ensemble de commutation (K1), et la première borne du second ensemble de commutation (K2) à déconnecter de la deuxième borne du second ensemble de commutation (K2).

5. Procédé de mesure de facteur de qualité basé sur un circuit oscillant (201, 301-303, 501) selon la revendication 4, dans lequel le calcul d'une valeur Q de la bobine d'induction (L) basé sur une première tension d'échantillonnage et une seconde tension d'échantillonnage comprend :

le calcul d'une valeur d'inductance équivalente de la bobine d'induction (L) en utilisant la formule 1 suivante, et le calcul d'une impédance équivalente de la bobine d'induction (L) en utilisant la formule 2 suivante :

$$L1 = \frac{R^2 Cp}{4\left(\sqrt{\frac{\left(\ln U1/Us\right)^2}{\left(n*\pi\right)^2 + \left(\ln U1/Us\right)^2}} - \sqrt{\frac{\left(\ln U2/Us\right)^2}{\left(n*\pi\right)^2 + \left(\ln U2/Us\right)^2}}\right)^2} \qquad \text{formule 1 ;}$$

$$R1 = \frac{R}{\dfrac{\sqrt{\dfrac{\left(\ln U1/Us\right)^2}{\left(n*\pi\right)^2 + \left(\ln U1/Us\right)^2}}}{\sqrt{\dfrac{\left(\ln U2/Us\right)^2}{\left(n*\pi\right)^2 + \left(\ln U2/Us\right)^2}}} - 1} \qquad \text{formule 2 ;}$$

et

le calcul de la valeur Q de la bobine d'induction (L) sur la base de la valeur d'inductance équivalente et de l'impédance équivalente, dans lequel L1 est la valeur d'inductance équivalente de la bobine d'induction (L), R1 est l'impédance équivalente de la bobine d'induction (L), Us est une tension de sortie de l'alimentation électrique (40, 504), U1 est la première tension d'échantillonnage, U2 est la seconde tension d'échantillonnage, R est une valeur de résistance de la résistance prédéterminée (R), n est un nombre entier positif et Cp est une valeur de capacité du condensateur (C).

6. Appareil de mesure de facteur de qualité basé sur un circuit oscillant (201, 301-303, 501), configuré pour commander un circuit de mesure de facteur de qualité basé sur un circuit oscillant (201, 301-303, 501), qui comprend : le circuit oscillant (201, 301-303, 501), un circuit de commande de mesure (502), et un circuit d'échantillonnage de tension (503), dans lequel le circuit de commande de mesure (502) est connecté à une alimentation électrique (40, 504), et le circuit de commande de mesure (502) est connecté au circuit oscillant (201, 301-303, 501) ; et le circuit oscillant (201, 301-303, 501) comprend un inducteur (L) et un condensateur (C) connectés en série, dans lequel une première borne de la bobine d'induction (L) est connectée au circuit de commande de mesure (502), une deuxième borne de la bobine d'induction (L) est connectée à une première borne du condensateur (C), et une deuxième borne du condensateur (C) est connectée à une borne de tension commune ou au circuit de commande de mesure (502) ; ou la deuxième borne du condensateur (C) est connectée au circuit de commande de mesure (502), la première borne du condensateur (C) est connectée à la deuxième borne de la bobine d'induction (L), et la première borne de la bobine d'induction (L) est connectée à la borne de tension commune ou au circuit de commande de mesure (502) ; et l'appareil de mesure de facteur de qualité basé sur un circuit oscillant (201, 301-303, 501) comprend :

un module de commande (2001), configuré pour commander le circuit de commande de mesure (502) afin de connecter la bobine d'induction (L) et le condensateur (C) à l'alimentation électrique (40, 504) en série pour former une boucle de charge afin de charger le condensateur (C), dans lequel

le module de commande (2001) est en outre configuré pour : commander le circuit de commande de mesure (502) afin de connecter la bobine d'induction (L) et le condensateur (C) pour former une boucle oscillante LC, dans lequel le circuit d'échantillonnage de tension (503) échantillonne une tension du condensateur (C) pour obtenir une première tension de crête du condensateur (C) ; ou commander le circuit de commande de mesure (502) pour connecter la bobine d'induction (L) et le condensateur (C) afin de former une boucle oscillante LC, et connecter une résistance prédéterminée (R) en série à la boucle oscillante LC, dans lequel le circuit d'échantillonnage de tension (503) échantillonne une tension du condensateur (C) pour obtenir une seconde tension de crête du condensateur (C) ; et

un module de traitement (2002), configuré pour calculer une valeur Q de la bobine d'induction (L) sur la base de la première tension de crête et de la seconde tension de crête obtenues par le circuit d'échantillonnage de tension (503) ;

**caractérisé en ce que** le circuit de commande de mesure (502) comprend un premier ensemble de commutation (K1), un second ensemble de commutation (K2) et la résistance prédéterminée (R) ; une première borne du premier ensemble de commutation (K1) est connectée à l'alimentation électrique (40, 504), une deuxième borne du premier ensemble de commutation (K1) est connectée à la borne de tension commune ou à la deuxième borne du condensateur (C), une troisième borne du premier ensemble de commutation (K1) est connectée à une première borne de la résistance prédéterminée (R), et une deuxième borne de la résistance prédéterminée (R) est connectée à la première borne de la bobine d'induction (L) ; et

une première borne du second ensemble de commutation (K2) est connectée à la première borne de la résistance prédéterminée (R), et une deuxième borne du second ensemble de commutation (K2) est connectée à la deuxième borne de la résistance prédéterminée (R) ; soit la première borne du premier ensemble de commutation (K1) est connectée à l'alimentation électrique (40, 504), la deuxième borne du premier ensemble de commutation (K1) est connectée à la borne de tension commune ou à la première borne de la bobine d'induction (L), la troisième borne du premier ensemble de commutation (K1) est connectée à la première borne de la résistance prédéterminée (R), et la deuxième borne de la résistance prédéterminée (R) est connectée à la deuxième borne du condensateur (C) ; et la première borne du second ensemble de commutation (K2) est connectée à la première borne de la résistance prédéterminée (R), et la deuxième borne du second ensemble de commutation (K2) est connectée à la deuxième borne de la résistance prédéterminée (R), dans lequel le module de commande (2001) est spécifiquement configuré pour commander la première borne du premier ensemble de commutation (K1) à connecter à la troisième borne du premier ensemble de commutation (K1), et la première borne du second ensemble de commutation (K2) à connecter à la deuxième borne du second ensemble de commutation (K2) ;

le module de commande (2001) est spécifiquement configuré pour commander la deuxième borne du premier ensemble de commutation (K1) à connecter à la troisième borne du premier ensemble de commutation (K1), et la première borne du second ensemble de commutation (K2) à connecter à la deuxième borne du second ensemble de commutation (K2) ; et

le module de commande (2001) est spécifiquement configuré pour commander la connexion de la deuxième borne du premier ensemble de commutation (K1) à la troisième borne du premier ensemble de commutation (K1), et la première borne du second ensemble de commutation (K2) à déconnecter de la deuxième borne du second ensemble de commutation (K2).

7. Dispositif électronique comprenant : le circuit de mesure de facteur de qualité basé sur un circuit oscillant (201, 301-303, 501) selon l'une quelconque des revendications 1 à 3, et l'appareil de mesure de facteur de qualité basé sur un circuit oscillant (201, 301-303, 501) selon la revendication 6, dans lequel le dispositif électronique peut être un dispositif émetteur ou un dispositif récepteur.

FIG. 1

FIG. 2

FIG. 3

FIG. 4

FIG. 5a

FIG. 5b

504          502          501          503

| Power supply | Measurement control circuit | Oscillating circuit<br>C ⊣⊢   L | Voltage sampling circuit |

**FIG. 5c**

504          502          501          503

| Power supply | Measurement control circuit | Oscillating circuit<br>C ⊣⊢   L | Voltage sampling circuit |

**FIG. 5d**

Control a measurement control circuit to connect an inductor and a capacitor to a power supply in series to form a charging loop to charge the capacitor — 601

Control the measurement control circuit to connect the inductor and the capacitor to form an LC oscillating loop, in which a voltage sampling circuit samples a voltage of the capacitor to obtain a first peak voltage U1 of the capacitor — 602

Control the measurement control circuit to connect the inductor and the capacitor to form an LC oscillating loop, and connect a predetermined resistor in series to the LC oscillating loop, in which the voltage sampling circuit samples a voltage of the capacitor to obtain a second peak voltage U2 of the capacitor — 603

Calculate a Q value of the inductor based on the first peak voltage and the second peak voltage — 604

FIG. 6

FIG. 7a

FIG. 7b

FIG. 7c

FIG. 7d

FIG. 8a

FIG. 8b

FIG. 9

FIG. 10

FIG. 11a

FIG. 11b

FIG. 12a

FIG. 12b

FIG. 13a

FIG. 13b

FIG. 14a

FIG. 14b

FIG. 15a

FIG. 15b

FIG. 16

FIG. 17a

FIG. 17b

FIG. 18a

EP 4 113 133 B1

FIG. 18b

FIG. 19

FIG. 20

Processor 2101
CPU0
CPU1

Processor 2104
CPU0
CPU1

Memory 2102

Interface circuit 2103

FIG. 21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013176023 A1

- CN 106953427 A